# EUROPEAN PATENT APPLICATION

(11) **EP 2 717 319 A1**
(43) Date of publication of application: **09.04.2014**
(21) Application number: 12788869.1
(22) Date of filing: 22.05.2012
(51) Int. Cl.: H01L 29/82, H01L 37/00

(54) **THERMOELECTRIC CONVERSION ELEMENT AND THERMOELECTRIC CONVERSION METHOD**

(30) Priority: 23.05.2011 JP 2011114301
(71) Applicant: NEC Corporation, Tokyo 108-8001 (JP); Tohoku University, Aoba-ku Sendai-shi Miyagi 980-8577 (JP)
(72) Inventor: KIRIHARA, Akihiro, Tokyo 108-8001 (JP); NAKAMURA, Yasunobu, Tokyo 108-8001 (JP); YOROZU, Shinichi, Tokyo 108-8001 (JP); UCHIDA, Kenichi, Sendai-shi Miyagi 980-8577 (JP); SAITOH, Eiji, Sendai-shi Miyagi 980-8577 (JP)
(74) Representative: Vossius & Partner
(86) International application number: PCT/JP2012/063576
(87) International publication number: WO 2012/161336

(57) **Abstract**

Provided is a thermoelectric conversion element capable of converting both a temperature gradient in an in-plane direction and a temperature gradient in a direction perpendicular to plane into electric power at the same time. The thermoelectric conversion element includes: a substrate (4); a magnetic film (2) provided on the substrate (4) and formed of a polycrystalline magnetic insulator material that is magnetizable in a predetermined direction having a component parallel to a film surface; and electrodes (3, 3a, and 3b) provided to the magnetic film (2) and made of a material having a spin orbit interaction. The thermoelectric conversion element is configured to be capable of outputting a temperature gradient perpendicular to a surface of the magnetic film (2) as a potential difference in a surface of one of the electrodes and outputting a temperature gradient parallel to the surface of the magnetic film (2) as a potential difference between the electrodes.

## Description

### Technical Field:

This invention relates to a thermoelectric conversion element and a thermoelectric conversion method which use a magnetic substance.

### Background Art:

In recent years, an expectation for a thermoelectric conversion element has been raised with intensified approaches to environmental and energy problems for the achievement of a sustainable society.

This is because heat is the most common energy source which can be obtained from various media such as a body heat, sunlight, an engine, and industrial exhaust heat.

Therefore, the thermoelectric conversion element is expected to be more and more important in the future for enhancement of efficiency of energy use in a low-carbon society and for intended use such as for power feeding to a ubiquitous terminal or sensor.

For power generation by thermoelectric conversion, a temperature difference (temperature gradient) generated by various heat sources is required to be appropriately used. Conventionally, a temperature gradient in a direction perpendicular to a heat source surface (direction perpendicular to plane) is generally used. For example, when a thermoelectric module is bonded to the high-temperature heat-source surface, a temperature difference is generated between a high-temperature side which is held in contact with the high-temperature heat source and a low-temperature side (air-cooled or water-cooled side) opposite thereto. As a result, power generation is enabled.

In order to use heat in an ambient surrounding us without waste for power generation in the future, it is indispensable to efficiently use not only the temperature gradient in the direction perpendicular to plane described above but also a temperature gradient in an in-plane direction of the heat source. In practice, a non-uniform in-plane temperature distribution is generated in buildings and IT devices under various situations. For example, in the case of a display, an upper part of the display has a higher temperature than that of a lower part due to a chimney effect. A server or the like also has non-uniform heat generation in some portions. Therefore, in order to effectively use the familiar ambient heat energy without waste as much as possible, a thermoelectric conversion element for both the direction perpendicular to plane and the in-plane direction, which can convert the temperature gradient in the in-plane direction simultaneously with the temperature gradient in the direction perpendicular to plane into electric power, is demanded.

In a conventional thermoelectric conversion element based on a thermocouple including a pair of two thermoelectric materials having different Seebeck coefficients, however, a direction of the temperature gradient in which the thermoelectric conversion can be performed is defined depending on a direction in which the thermocouple is disposed. Specifically, only the temperature gradient in a direction parallel to the thermocouple structure is converted into a thermoelectromotive force. The direction of the temperature gradient which can be used for thermoelectric generation is limited to one direction. Therefore, the conventional thermoelectric conversion element based on the thermocouple is incapable of simultaneously converting the temperature gradient in the direction perpendicular to plane and the temperature gradient in the in-plane direction of the heat source into electric power.

On the other hand, in recent years, a new effect called spin Seebeck effect for generating a flow of a momentum of a spin angle by the application of the temperature gradient to a magnetic material has been discovered. Patent Literature 1 and Non Patent Literatures 1 and 2 describe a thermoelectric conversion element based on the spin Seebeck effect, and disclose a structure for extracting a flow of the angular momentum, which is generated by the spin Seebeck effect (spin current), as a current (electromotive force) by an inverse spin-hall effect (Patent Literature 1 and Non Patent Literatures 1 and 2).

For example, the thermoelectric conversion element described in Patent Literature 1 includes a ferromagnetic film and an electrode, which are formed by a sputtering method. When the temperature gradient in a direction parallel to a surface of the ferromagnetic film is applied, the spin current is induced in a direction along the temperature gradient due to the spin Seebeck effect. The induced spin current can be extracted to outside as a current by the inverse spin-hall effect generated in the electrode which is held in contact with the magnetic substance. As a result, the power generation based on the temperature difference, for extracting electric power from heat, can be performed.

Each of the thermoelectric conversion elements described in Non Patent Literatures 1 and 2 includes a magnetic substance and an electrode. Non Patent Literature 1 reports thermoelectric conversion by the arrangement in which the temperature gradient parallel to the surface of the magnetic film (temperature gradient in the in-plane direction) is applied, as in the case of Patent Literature 1. In Non Patent Literature 2, the thermoelectric conversion is proven by the arrangement in which a perpendicular temperature gradient (temperature gradient in the direction perpendicular to plane) is applied to a surface of a magnetic film having a thickness of 1 mm.

The conventional thermoelectric conversion element is configured by arranging a pair of two types of thermoelectric materials (thermocouple). In view of the spin Seebeck effect, an up-spin channel and a down-spin channel in the magnetic substance correspond to a pair of two different thermoelectric channels. Specifically, it is considered that a function of the thermocouple is embedded in the magnetic-substance material. Therefore, in principle, the spin current can be generated for any direction of the temperature gradient.

### Citation List:

### Patent Literature:

Patent Literature 1: JP 2009-130070 A

### Non Patent Literature:

Non Patent Literature 1: Uchida et al., "Spin Seebeck insulator", Nature Materials, 2010, vol. 9, p. 894.
Non Patent Literature 2: Uchida et al., "Observation of longitudinal spin-Seebeck effect in magnetic insulators", Applied Physics Letters, 2010, vol. 97, p172505.

### Disclosure of the Invention:

### Problem to be Solved by the Invention:

The thermoelectric conversion elements using the spin-Seebeck effect as described in Patent Literature 1 and Non Patent Literatures 1 and 2 have an excellent structure in that a large area can be easily achieved at low cost and thin-film thermoelectric conversion is enabled.

However, a thermoelectric conversion element which can convert both the temperature gradient in the in-plane direction and the temperature gradient in the direction perpendicular to plane into electric power with high efficiency at the same time has not been realized yet. For all the thermoelectric conversion elements disclosed in Patent Literature 1 and Non Patent Literatures 1 and 2, materials, shapes, arrangement, and thermal conduction characteristics (for example, a thermal conductivity) of the magnetic substance, the substrate, the electrode, and the like are selected uniquely for the conversion of any one of the temperature gradient in the in-plane direction and the temperature gradient in the direction perpendicular to plane into the electric power. In order to realize the thermoelectric conversion element which converts both the temperature gradient in the in-plane direction and the temperature gradient in the direction perpendicular to plane into the electric power with high efficiency at the same time, it is necessary to specifically examine the materials, the shapes, the arrangement, and the thermal conduction characteristics of the magnetic substance, the substrate, the electrode, and the like to find which element structure is effective, but the above-mentioned element structure has not been found yet.

This invention has been made to solve the problem described above, and therefore has an object to provide a thermoelectric conversion element capable of converting both a temperature gradient in an in-plane direction and a temperature gradient in a direction perpendicular to plane into electric power at the same time.

### Means to Solve the Problem:

In order to achieve the above-mentioned object, according to a first embodiment of this invention, there is provided a thermoelectric conversion element including: a magnetic film provided on a substrate and formed of a magnetic substance that is magnetizable in a predetermined direction having a component parallel to a film surface; and a plurality of electrodes provided to the magnetic film and made of a material having a spin orbit interaction, the plurality of electrodes being arranged along the predetermined direction. The thermoelectric conversion element is configured to be capable of outputting a temperature gradient perpendicular to a surface of the magnetic film as a potential difference in any of surfaces of the plurality of electrodes and outputting a temperature gradient parallel to the surface of the magnetic film as a potential difference in any of the surfaces of the plurality of electrodes.

According to a second embodiment of this invention, there is provided a thermoelectric conversion method including: applying a temperature gradient to the magnetic film of the thermoelectric conversion element according to the first embodiment to generate a spin current flowing from the magnetic film to the plurality of electrodes; and generating a current in a direction perpendicular to the predetermined direction by an inverse spin-hall effect generated in the plurality of electrodes.

### Effect of the Invention:

According to this invention, it is possible to provide the thermoelectric conversion element capable of converting both the temperature gradient in the in-plane direction and the temperature gradient in the direction perpendicular to plane into electric power at the same time.

### Brief Description of the Drawings:

Fig. 1 is a perspective view illustrating a thermoelectric conversion element 1 according to a first embodiment of this invention.
Fig. 2 is a perspective view illustrating generation of a thermoelectromotive force when a temperature gradient is applied to the thermoelectric conversion element 1 in a direction perpendicular to plane.
Fig. 3 is a sectional view taken along the line D1-D1 of Fig. 2.
Fig. 4 is a perspective view illustrating generation of thermoelectromotive forces when the temperature gradient is applied to the thermoelectric conversion element 1 in an in-plane direction.
Fig. 5 is a sectional view taken along the line D2-D2 of Fig. 4.
Fig. 6 is a perspective view illustrating a thermoelectric conversion element 1a according to a second embodiment of this invention and a partially enlarged view of a substrate 4a.
Fig. 7 is a sectional view illustrating a thermal conduction characteristic when the temperature gradient is applied to the thermoelectric conversion element 1a in the direction perpendicular to plane.
Fig. 8 is a sectional view illustrating a thermal conduction characteristic when the temperature gradient is applied to the thermoelectric conversion element 1a in the in-plane direction.
Fig. 9 is a perspective view illustrating a thermoelectric conversion element 1b according to a third embodiment of this invention.
Fig. 10 is a front view of Fig. 9.
Fig. 11 is a back view of Fig. 9.
Fig. 12 is a sectional view illustrating a thermal conduction characteristic when the temperature gradient is applied to the thermoelectric conversion element 1b in the direction perpendicular to plane.
Fig. 13 is a sectional view illustrating a thermal conduction characteristic when the temperature gradient is applied to the thermoelectric conversion element 1b in the in-plane direction.
Fig. 14 is a view illustrating a procedure of manufacture of a substrate 4b of the thermoelectric conversion element 1b.
Fig. 15 is another view illustrating the procedure of manufacture of the substrate 4b of the thermoelectric conversion element 1b.
Fig. 16 is a further view illustrating the procedure of manufacture of the substrate 4b of the thermoelectric conversion element 1b.
Fig. 17 is a perspective view illustrating a thermoelectric conversion element 1c according to a fourth embodiment of this invention.
Fig. 18 is a perspective view illustrating generation of thermoelectromotive forces when the temperature gradient is applied to the thermoelectric conversion element 1c in the direction perpendicular to plane.
Fig. 19 is a sectional view taken along the line D3-D3 of Fig. 18.
Fig. 20 is a perspective view illustrating generation of thermoelectromotive forces when the temperature gradient is applied to the thermoelectric conversion element 1c in the in-plane direction.
Fig. 21 is a sectional view taken along the line D4-D4 of Fig. 20.
Fig. 22 is a perspective view illustrating a thermoelectric conversion element 1d according to a fifth embodiment of this invention.
Fig. 23 is a perspective view illustrating generation of a thermoelectromotive force when the temperature gradient is applied to the thermoelectric conversion element 1d in the direction perpendicular to plane (z-direction).
Fig. 24 is a perspective view illustrating generation of thermoelectromotive forces when the temperature gradient is applied to the thermoelectric conversion element 1d in the in-plane direction (y-direction).
Fig. 25 is a perspective view illustrating generation of a thermoelectromotive force when the temperature gradient is applied to the thermoelectric conversion element 1d in the direction perpendicular to plane (z-direction).
Fig. 26 is a perspective view illustrating generation of thermoelectromotive forces when the temperature gradient is applied to the thermoelectric conversion element 1d in the in-plane direction (x-direction).
Fig. 27 is a perspective view illustrating a thermoelectric conversion element 1e according to a sixth embodiment of this invention.
Fig. 28 is a perspective view illustrating generation of thermoelectromotive forces when the temperature gradient is applied to the thermoelectric conversion element 1e in the direction perpendicular to plane.
Fig. 29 is a perspective view illustrating generation of thermoelectromotive forces when the temperature gradient is applied to the thermoelectric conversion element 1e in the in-plane direction.
Fig. 30 is a perspective view illustrating generation of thermoelectromotive forces when the temperature gradient is applied to the thermoelectric conversion element 1e in the direction perpendicular to plane.
Fig. 31 is a perspective view illustrating generation of thermoelectromotive forces when the temperature gradient is applied to the thermoelectric conversion element 1e in the in-plane direction.
Fig. 32 is a perspective view illustrating a thermoelectric conversion element 1f corresponding to a variation of the sixth embodiment.
Fig. 33 is a perspective view illustrating generation of thermoelectromotive forces when the temperature gradient is applied to the thermoelectric conversion element If in the direction perpendicular to plane.
Fig. 34 is a perspective view illustrating generation of thermoelectromotive forces when the temperature gradient is applied to the thermoelectric conversion element 1f in the in-plane direction.
Fig. 35 is a perspective view illustrating a thermoelectric conversion element 1g according to a seventh embodiment of this invention.
Fig. 36 is a perspective view illustrating generation of thermoelectromotive forces when the temperature gradient is applied to the thermoelectric conversion element 1g in the direction perpendicular to plane.
Fig. 37 is a perspective view illustrating generation of thermoelectromotive forces when the temperature gradient is applied to the thermoelectric conversion element 1g in the in-plane direction.
Fig. 38 is a perspective view illustrating a thermoelectric conversion element 1h according to an eighth embodiment of this invention.
Fig. 39 is a perspective view illustrating a thermoelectric conversion element 1i according to a ninth embodiment of this invention.

### Detailed Description of Exemplary Embodiments:

Now, preferred embodiments of this invention are specifically described referring to the drawings.

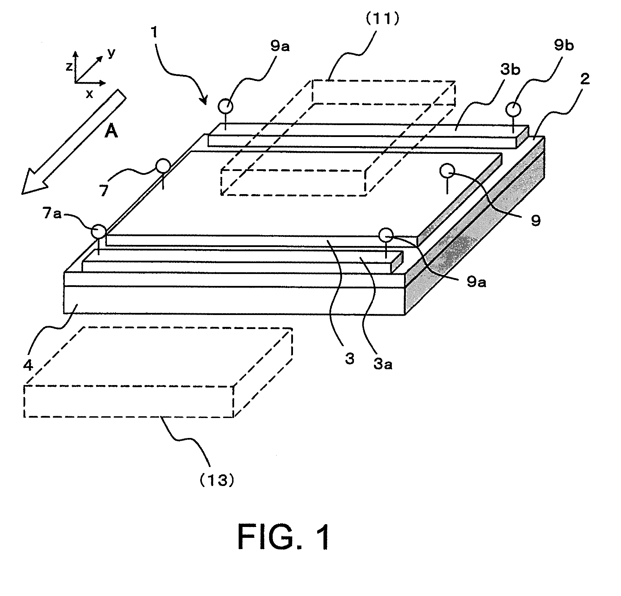

First, a first embodiment of this invention is specifically described referring to Figs. 1 to 5.

A schematic configuration of a thermoelectric conversion element 1 according to the first embodiment is first described referring to Fig. 1.

As illustrated in Fig. 1, the thermoelectric conversion element 1 includes a magnetic film 2 held on a substrate 4, for generating a spin current by a temperature gradient, and electrodes 3, 3a, and 3b provided on the magnetic film 2, for extracting a thermoelectromotive force from the spin current by using an inverse spin-hall effect. The magnetic film 2 and the electrodes 3, 3a, and 3b constitute a power-generating section. A positional relationship between the electrodes 3, 3a, and 3b and the magnetic film 2 illustrated in Fig. 1 may be inverted.

As described later, the electrode 3 (central electrode) is an electrode for extracting a spin current in a direction perpendicular to plane as an electromotive force, and is provided on the center of an upper part of the magnetic film 2.

As described later, the electrodes 3a and 3b (end electrodes) are electrodes for extracting a spin current in an in-plane direction as an electromotive force, and are provided on front and rear ends of the magnetic film 2 so as to be opposed to each other across the electrode 3.

As a result of detailed examination of the arrangement of electrodes based on a spin-Seebeck effect, the inventors of this invention have found that it is effective to dispose the electrodes 3a and 3b on the ends of a magnetic substance so as to convert the spin current generated by the temperature gradient in the in-plane direction into electric power as large as possible. Further, the inventors have found that larger electric power is obtained when the electrode 3 for obtaining the electric power by the temperature gradient in the direction perpendicular to plane has a larger area but the amount of obtained electric power is the same regardless of a position on the surface of the magnetic film 2, at which the electrode 3 is disposed. As a result of the examinations described above, as illustrated in Fig. 1 the electrodes 3a and 3b are provided on both ends of the magnetic film 2, whereas the electrode 3 having a higher degree of freedom in the arrangement is provided between the electrodes 3a and 3b. Further, as illustrated in Fig. 1, it is preferred to configure the electrode 3 for obtaining the electric power by the temperature gradient in the direction perpendicular to plane to have a larger area on a plane than that of each of the electrodes 3a and 3b so as to obtain larger electric power.

Further, the thermoelectric conversion element 1 includes terminals 7 and 9 for extracting the thermoelectromotive force, which are formed removably at two positions on the electrode 3, terminals 7a and 9a formed removably at two positions on the electrode 3a, and terminals 7b and 9b formed removably at two positions on the electrode 3b. The terminals form thermoelectromotive-force outputting means.

Further, the thermoelectric conversion element 1 includes temperature-gradient application means 11 for applying the temperature gradient to the magnetic film 2, as needed.

Moreover, the thermoelectric conversion element 1 includes magnetization means 13 for magnetizing the magnetic film 2 in a predetermined direction (direction A of Fig. 1 in this case), as needed.

Next, elements of the thermoelectric conversion element 1 are specifically described.

Any material and structure can be used for the substrate 4 as long as the substrate 4 can support the magnetic film 2 and the electrodes 3, 3a, and 3b. For example, a substrate made of a material such as Si, glass, alumina, sapphire, gadolinium gallium garnet (GGG), or polyimide can be used. A shape is not necessarily required to be a plate-like one, and may have a structure which is curved or has concavity and convexity. Further, a building or the like can also be directly used as the substrate 4. Moreover, in a structure or under situations in which the magnetic film 2 can be fixed to a heat source (specifically, in a structure or under situations in which the heat source can also serve as the substrate 4), for example, by placing the magnetic film 2 on the heat source, the substrate 4 is not always additionally required. The heat source itself can also be used as a base substance (substrate 4) for supporting the thermoelectric conversion element 1.

The magnetic film 2 is made of a polycrystalline magnetic substance which can be magnetized at least in one magnetization direction A. In the first embodiment, it is supposed that the magnetic film 2 has a magnetization direction in one direction parallel to a film surface (the magnetization direction A has at least a component parallel to the film surface). The magnetic film 2 has a more efficient thermoelectric effect for a material having a smaller thermal conductivity. Therefore, it is preferred that the magnetic film 2 be a magnetic insulator. As such a material, for example, an oxide magnetic material such as garnet ferrite (such as yttrium iron garnet) or spinel ferrite can be used.

A material obtained by partially substituting an yttrium site of garnet ferrite by an impurity such as Bi may be used for the magnetic film 2. By substituting the yttrium site by an impurity in this manner, it is considered that matching between energy levels of the magnetic film 2 and the electrode 3 is improved. Therefore, there is a possibility that an extraction efficiency of the spin current at an interface therebetween is increased to improve thermoelectric conversion efficiency.

As a specific composition, yttrium iron garnet doped with Bi expressed by BiₓY₃₋ₓFe₅O₁₂ (0.5≤x≤1.5) is given.

An element used for doping is not limited to Bi, and other impurities may also be used as long as the matching between the energy levels of the magnetic film 2 and the electrode 3 is improved.

In this case, as a method of forming the magnetic film 2, methods such as liquid-phase epitaxial growth (LPE), sputtering, laser ablation (PLD), a metal-organic deposition method (MOD method), a sol-gel method, an aerosol deposition method (AD method) can be given as described later. A bulk magnetic substance obtained by a Czochralski method or sintering may be used.

When a magnetic material having a coercive force is used for the magnetic film 2, an element which is capable of operating even under a zero magnetic field is obtained after a magnetization direction is once initialized by an external magnetic field.

The electrodes 3, 3a, and 3b are made of a material having a spin orbit interaction so as to extract the thermoelectromotive force by using the inverse spin-hall effect. As such a material, for example, a metal having a relatively large spin orbit interaction, such as Au, Pt, or Pd, or an alloy thereof is given. In order to enhance the inverse spin-hall effect, a material obtained by adding an impurity such as Fe or Cu to the above-mentioned metal or alloy may be used as a material of the electrodes 3, 3a, and 3b.

The electrodes 3, 3a, and 3b are formed by forming films on the magnetic film 2 by sputtering, vapor deposition, plating, screen printing, or the like. A thickness of the electrodes is preferably set at least to be longer than a length of spin diffusion of the electrode material. Specifically, for example, the thickness is desirably set to 50 nm or larger for Au and 10 nm or larger for Pt.

Any structure, shape, and position may be used for the terminals 7, 9, 7a, 9a, 7b, and 9b as long as a potential difference between the terminals can be extracted as the thermoelectromotive force. In order to obtain the potential difference as large as possible, the terminals are desirably provided at two positions on the respective ends of the magnetic film 2 in a direction perpendicular to the magnetization direction A (so that a line segment connecting the terminals 7 and 9, a line segment connecting the terminals 7a and 9a, and a line segment connecting the terminals 7b and 9b are perpendicular to the magnetization direction A).

Any means may be used as the temperature-gradient application means 11 as long as the temperature gradient is applied to the magnetic film 2. Various types of heaters or a thermal conductor for conducting heat such as body heat, heat of sunlight, engine heat, or industrial exhaust heat to the magnetic film 2 can be used.

When the heat source directly conducts heat to the magnetic film, the temperature-gradient application means 11 is not always indispensable.

The magnetization means 13 is a device for magnetizing the magnetic film 2 in the magnetization direction A. Any structure, material, and kind of the magnetization means is used as long as the magnetization of the magnetic film 2 is maintained. Specifically, for example, besides a magnetic-field generator using a coil or the like, a magnet or the like can be provided in proximity for use. Alternatively, another ferromagnetic film or an antiferromagnetic film may be provided in proximity to the magnetic film 2 so as to maintain the magnetization of the magnetic film 2 by means such as a magnetic interaction.

Next, an operation of the thermoelectric conversion element 1 is described referring to Figs. 1 to 5.

First, in the thermoelectric conversion element 1 illustrated in Fig. 1, after a magnetic field is applied to the magnetic film 2 by using the magnetization means 13 so that the magnetic field 2 is magnetized in the magnetization direction A, the temperature gradient is applied by using the temperature-gradient application means 11 or the like.

Then, by the spin-Seebeck effect generated in the magnetic film 2, an angular motion (spin current) is induced in a direction of the temperature gradient. In contrast to a conventional thermoelectric module in which a temperature-gradient direction capable of generating the thermoelectromotive force is limited by a thermocouple structure, the spin-Seebeck effect in the magnetic substance does not have such structural anisotropy, and therefore the spin current can be generated by a temperature gradient in any direction.

In order to extract the spin current generated by the temperature gradient in any direction as an electromotive force, the electrode 3 is disposed on the center of the upper part of the magnetic film 2 and the electrodes 3a and 3b are disposed in the front and rear ends of the magnetic film 2 in the drawing in the first embodiment. By the electrodes described above, the spin current in any direction in the magnetic substance can be extracted as an electromotive force.

The spin current generated by the magnetic film 2 flows into the electrodes 3, 3a, and 3b in proximity, and is then converted into a current by the inverse spin-hall effect in the electrodes 3, 3a, and 3b.

The current generates a potential difference any of between the terminals 7 and 9, between the terminals 7a and 9a, and between the terminals 7b and 9b. Therefore, the potential difference can be extracted from the terminals 7 and 9, 7a and 9a, or 7b and 9b as the thermoelectromotive force.

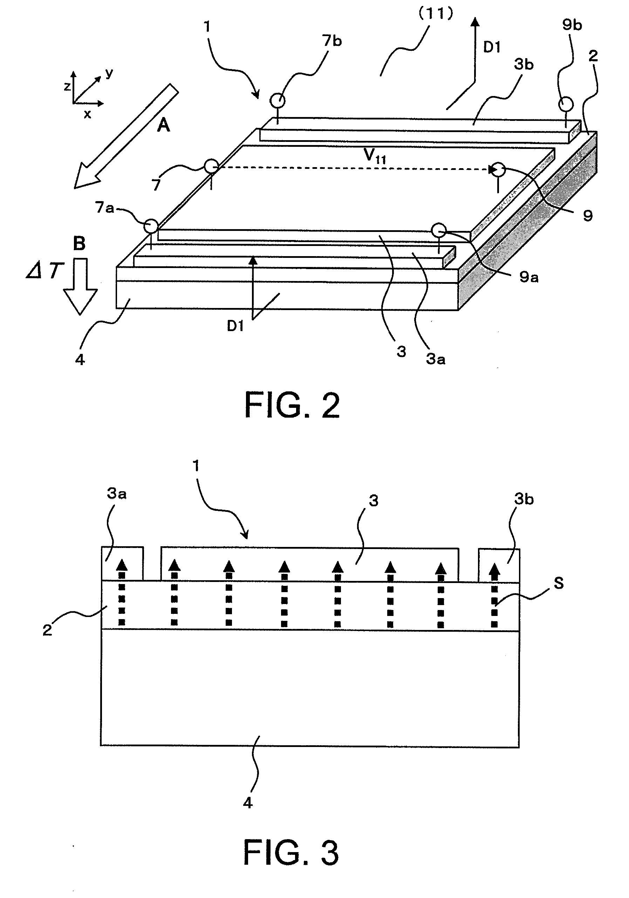

As a specific example of operation, when a temperature gradient having a component perpendicular to an element surface of the thermoelectric conversion element 1 (direction perpendicular to plane) is applied, the spin current is generated in the magnetic film 2 in the direction perpendicular to plane and mainly flows into the electrode 3, as illustrated in Figs. 2 and 3. Thereafter, by the inverse spin-hall effect in the electrode 3, the spin current is converted into a current in a direction perpendicular to the magnetization direction of the magnetic film 2. As a result, the potential difference between the terminals 7 and 9 can be extracted as a thermoelectromotive force V₁₁.

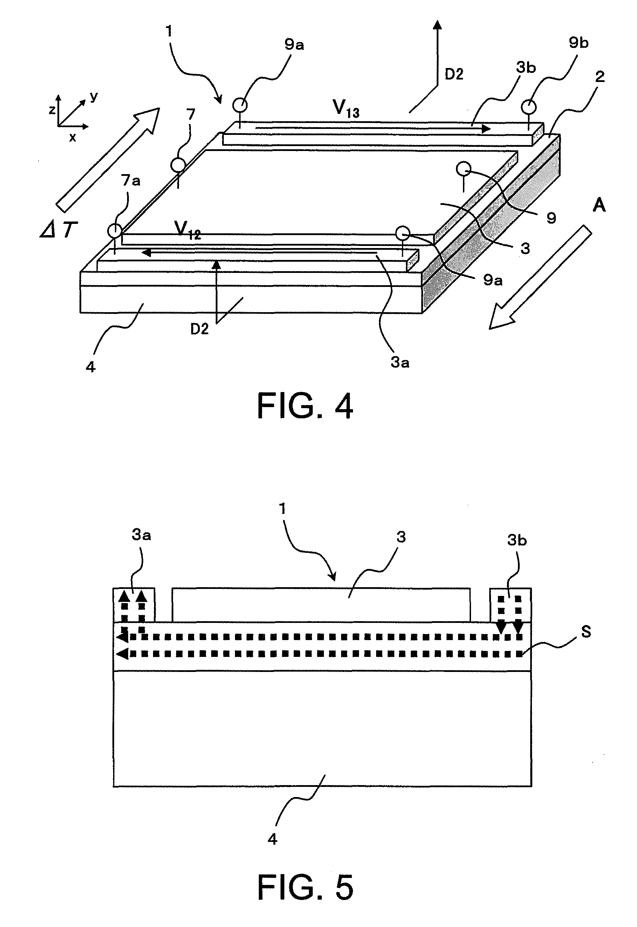

On the other hand, when the temperature gradient is applied in a direction parallel to the element surface (in-plane direction), as illustrated in Figs. 4 and 5, the spin current is generated in the magnetic film 2 in the in-plane direction and mainly flows into the electrodes 3a and 3b. By the inverse spin-hall effect in the electrodes 3a and 3b, the spin current is converted into a current in a direction perpendicular to the magnetization direction of the magnetic film 2. As a result, the potential difference between the terminals 7a and 9a can be extracted as a thermoelectromotive force V₁₂, whereas the potential difference between the terminals 7b and 9b can be extracted as a thermoelectromotive force V₁₃. In the electrodes 3a and 3b, the direction of the flow of the spin current at the interface with the magnetic film 2 is different. Therefore, the electromotive forces are generated in directions antiparallel to each other.

Figs. 2 and 3 illustrate the case with the temperature gradient in the direction perpendicular to plane, whereas Figs. 4 and 5 illustrate the case with the temperature gradient in the in-plane direction. Even in an intermediate case, specifically, with a temperature gradient in an oblique direction having an inclination θ expressed by 0°<θ<90° with respect to the magnetic film 2 in a y-z plane illustrated in Fig. 1, the thermoelectromotive force can be extracted with high efficiency. In this case, when an oblique temperature-gradient vector is decomposed into a component in the direction perpendicular to plane (θ=90°) and a component in the in-plane direction (θ=0°), the thermoelectromotive forces are simultaneously generated in the electrode 3 for the component in the direction perpendicular to plane and in the electrodes 3a and 3b for the in-plane component.

By the arrangement of the electrodes described above, the thermoelectric conversion element 1 can generate electric power for any of the temperature gradients in the direction perpendicular to plane and the in-plane direction.

As described above, according to the first embodiment, the thermoelectric conversion element 1 includes the substrate 4, the magnetic film 2 provided on the substrate 4 and formed of the polycrystalline magnetic insulator material which can be magnetized in the predetermined direction, and the electrodes 3, 3a, and 3b provided on the magnetic film 2 and made of the material having the spin orbit interaction, and is configured to be capable of outputting the temperature gradient in the direction perpendicular to plane in the magnetic film 2 as the potential difference in the surface of the electrode 3 and the temperature gradient in the in-plane direction in the magnetic film 2 as the potential differences in the surfaces of the electrodes 3a and 3b.

Therefore, the thermoelectric conversion element 1 can simultaneously convert both the temperature gradient in the in-plane direction and the temperature gradient in the direction perpendicular to plane into the electric power.

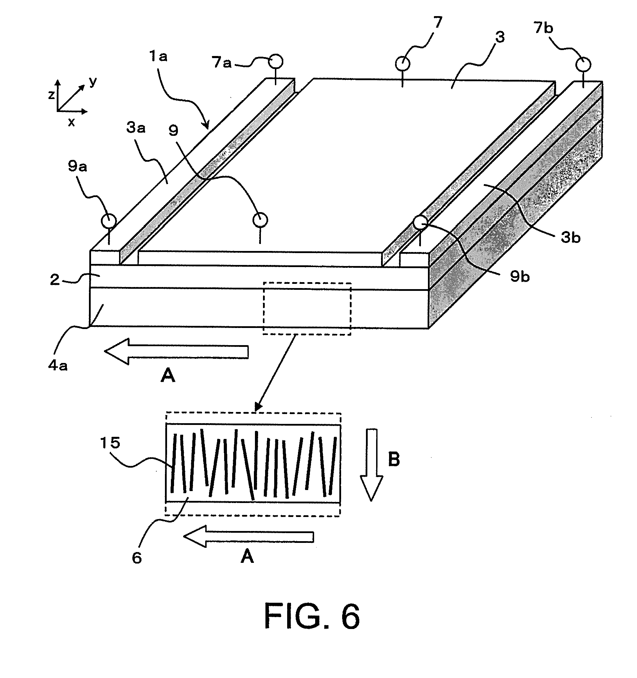

Next, a second embodiment of this invention is specifically described referring to Figs. 6 to 8.

The second embodiment corresponds to a variation of the first embodiment in which a material provided with thermal conduction anisotropy by containing fillers 15 is used for a substrate 4a.

In the second embodiment, the elements having the same functions as those of the first embodiment are denoted by the same reference symbols. Therefore, differences from the first embodiment are mainly described.

As illustrated in Fig. 6, the substrate 4a of a thermoelectric conversion element 1a has a structure including a plate-like substrate support 6 and a plurality of the fillers 15 unidirectionally oriented, which are contained in the substrate support 6.

For the substrate support 6, a material having a thermal conductivity smaller than that of the fillers 15, such as an epoxy resin or an organic resin, is used. For the fillers 15, a material having a thermal conductivity larger than that of the substrate support 6, such as carbon fibers, alumina, or boron nitride is used. By the structure described above, the thermal conductivity in the direction in which the fillers 15 are oriented becomes larger than the thermal conductivity in the direction perpendicular to the direction of orientation in the substrate 4a. As a result, the thermal conduction anisotropy is generated.

In Fig. 6, the fillers 15 are oriented in the direction perpendicular to plane in the substrate 4a, and a configuration is such that the thermal conductivity in the direction perpendicular to plane becomes higher than that in the in-plane direction.

By using the substrate 4a having the thermal conduction anisotropy described above, thermoelectric conversion with higher efficiency is enabled as compared with the case where a substrate without thermal conduction anisotropy is used. The reason is as follows. In order to maximize thermoelectric conversion performance for a given heat source, a portion of the magnetic film 2, in which the spin-Seebeck effect is exerted, is required to maintain a temperature difference as large as possible. By using the substrate 4a having anisotropy, the above-mentioned condition is simultaneously satisfied in both the direction perpendicular to plane and the in-plane direction.

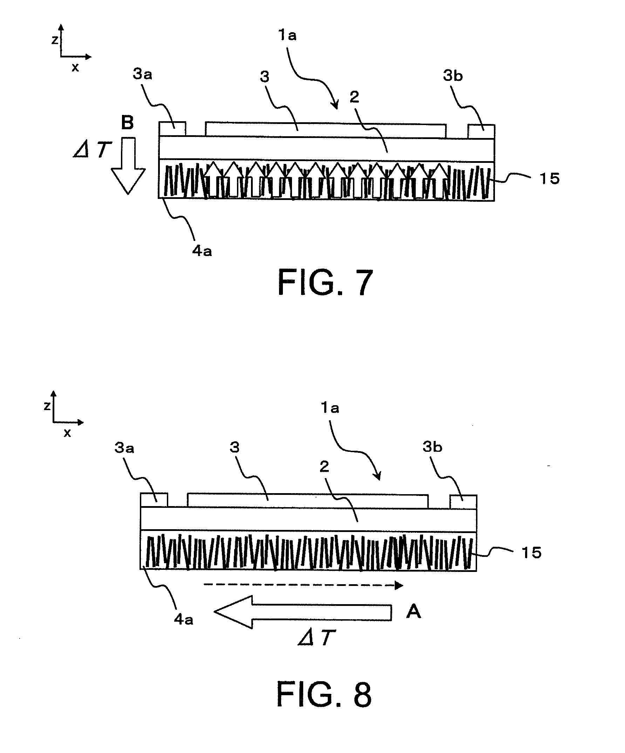

The reason is now specifically described referring to Figs. 7 and 8.

First, as illustrated in Fig. 7, the case where the temperature gradient in the direction perpendicular to plane of the thermoelectric conversion element 1 is generated is considered. In this case, a temperature difference is applied to the magnetic film 2 and the substrate 4a in series. In the substrate 4a, the thermal conductivity in the direction perpendicular to plane is higher than that in the in-plane direction (has a smaller thermal resistance). Therefore, a larger temperature difference is applied to a portion of the magnetic film 2 (see a plurality of outlined arrows illustrated in Fig. 7) in an effective manner. In this manner, the large thermoelectromotive force can be generated for the temperature gradient in the direction perpendicular to plane.

Next, as illustrated in Fig. 8, when the temperature gradient is generated in the in-plane direction of the thermoelectric conversion element 1, the temperature difference is applied in parallel to the magnetic film 2 and the substrate 4a. In this case, the thermal conductivity in the in-plane direction of the substrate 4a is smaller than that in the direction perpendicular to plane (has a larger thermal resistance). Therefore, a heat flow is unlikely to flow in the in-plane direction of the substrate 4a (see the arrow in a dotted line in Fig. 8). As a result, a large temperature difference can be maintained between both ends of the magnetic film 2. In this manner, the large thermoelectromotive force can be generated also for the temperature gradient in the in-plane direction.

By the configuration described above, a thermoelectric device capable of thermoelectrically generating power with high efficiency for any of the temperature gradient in the direction perpendicular to plane and the temperature gradient in the in-plane direction can be configured. Although a structure in which the oriented fillers 15 are contained in the substrate support 6 is used as the substrate 4a, a method of generating the thermal conduction anisotropy is not limited thereto. For example, even when a structure having a high thermal conduction characteristic is embedded into the substrate support 6 so as to extend in the direction perpendicular to plane, the same effects can be obtained.

Moreover, in this case, the effects are obtained when the thermal conductivity of the substrate 4a in the direction perpendicular to plane is larger than the thermal conductivity in the in-plane direction. In order to maintain a large temperature difference in the magnetic film 2 in particular, it is preferred that the thermal conductivity of the substrate 4a in the direction perpendicular to plane be higher than a perpendicular thermal conductivity of the magnetic film 2, and a horizontal thermal conductivity of the substrate 4a be lower than a horizontal thermal conductivity of the magnetic film 2.

Protective layers may be provided between the electrodes 3, 3a, and 3b, or thereon, as needed. In this case, it is preferred that the protective films be configured so that the thermal conductivity in the direction perpendicular to plane becomes higher than that in the in-plane direction.

As described above, according to the second embodiment, the thermoelectric conversion element 1a includes the substrate 4a, the magnetic film 2 provided on the substrate 4a and formed of the polycrystalline magnetic insulator material which can be magnetized in the predetermined direction, and the electrodes 3, 3a, and 3b provided on the magnetic film 2 and are made of the material having the spin orbit interaction, and is configured to be capable of outputting the temperature gradient in the direction perpendicular to plane in the magnetic film 2 as the potential difference in the surface of the electrode 3 and the temperature gradient in the in-plane direction in the magnetic film 2 as the potential differences in the surfaces of the electrodes 3a and 3b.

Therefore, the same effects as those of the first embodiment are provided.

Moreover, according to the second embodiment, in the thermoelectric conversion element 1a, the substrate 4a has a structure including the substrate support 6 and the plurality of fillers 15 contained in the substrate support 6, which are unidirectionally oriented, and therefore has the thermal conduction anisotropy.

Therefore, as compared with the first embodiment, the thermoelectric conversion with higher efficiency is enabled.

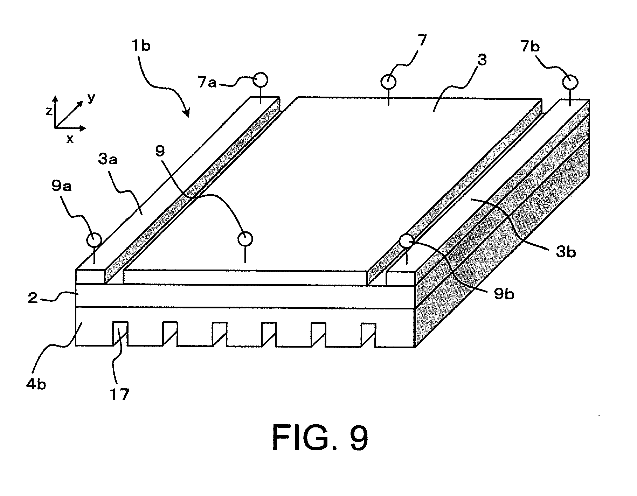

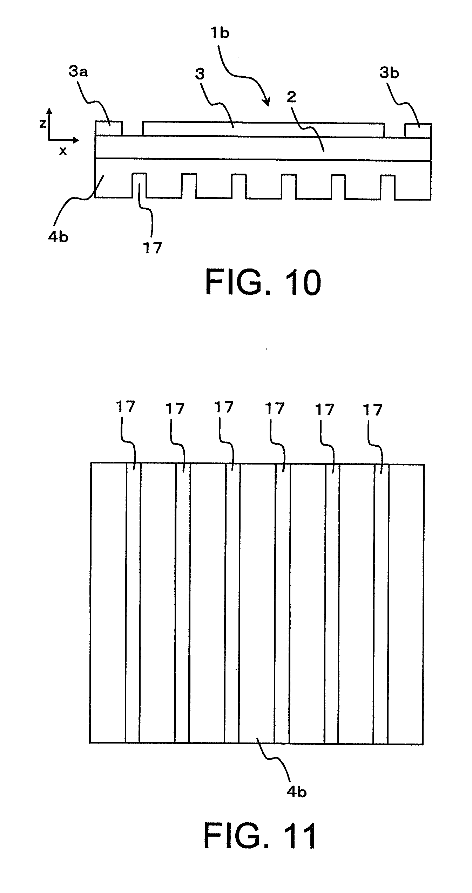

Next, a third embodiment of this invention is described referring to Figs. 9 to 16.

Similarly to the second embodiment, the thermal conduction anisotropy is provided to a substrate in the third embodiment. In contrast to the second embodiment, however, the thermal conduction anisotropy is provided to the substrate not by a material but by a shape.

In the third embodiment, the elements having the same functions as those of the first embodiment are denoted by the same reference symbols. Therefore, differences from the first embodiment are mainly described.

As illustrated in Figs. 9 to 11, a thermoelectric conversion element 1b according to the third embodiment includes a substrate 4b having elongated slits 17 for blocking thermal conduction in the in-plane direction, which are provided at least in one surface thereof. In Fig. 9, the slits 17 are formed in parallel to the direction perpendicular to plane.

By the structure described above, similarly to the substrate 4a, the substrate 4b has a higher thermal conduction characteristic in the direction perpendicular to plane than that in the in-plane direction perpendicular to the slits 17, and therefore has the thermal conduction anisotropy.

As described above, the thermal conduction anisotropy can be generated by modifying the shape of the substrate.

By using the substrate 4b having the thermal conduction anisotropy, the thermoelectric conversion with high efficiency is enabled in both the direction perpendicular to plane and the in-plane direction, as in the second embodiment.

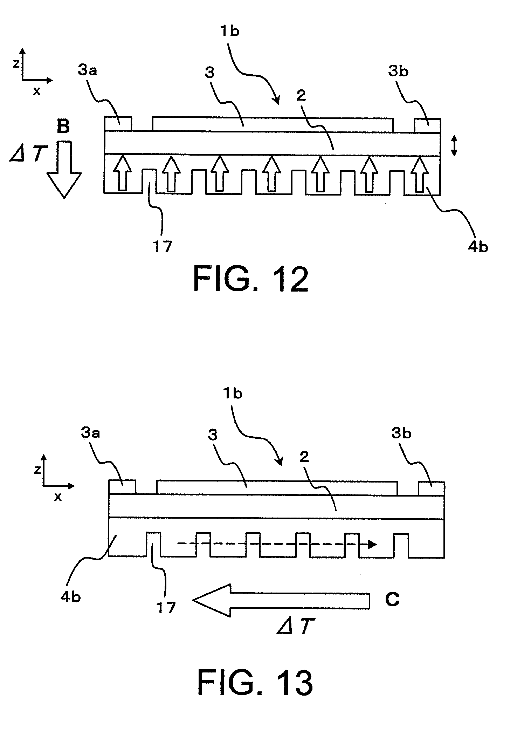

Specifically, as illustrated in Fig. 12, when the temperature gradient is applied in the direction perpendicular to plane (direction indicated by the plurality of outlined arrows illustrated in Fig. 12) of the thermoelectric conversion element 1b, a large temperature difference is effectively applied to a portion of the magnetic film 2 because the substrate 4b has a relatively large thermal conduction characteristic (has a smaller thermal resistance) in the direction perpendicular to plane. In this manner, a large thermoelectromotive force can be generated for the temperature gradient in the direction perpendicular to plane.

On the other hand, as illustrated in Fig. 13, when the temperature gradient is applied to the thermoelectric conversion element 1 in the in-plane direction, the thermal conduction in the in-plane direction of the substrate 4b is blocked by the slits 17. As a result, the heat flow is unlikely to flow in the in-plane direction of the substrate 4b (see the arrow in a dotted line illustrated in Fig. 13). As a result, a large temperature difference between both ends of the magnetic film 2 is maintained. In this manner, a large thermoelectromotive force can be generated also for the temperature gradient in the in-plane direction.

Although a structure in which linear elongated cuts are arranged is used as the slits 17, the shape of the slits 17 is not limited thereto. For example, a structure having cuts in a lattice pattern or a plurality of holes may be used. Any details such as a pattern shape may be used as long as a structure generates the thermal conduction anisotropy in the direction perpendicular to plane and the in-plane direction. A material having a smaller thermal conductivity than that of the substrate 4b may be embedded in the slits 17 in order to enhance a mechanical strength.

As a method of forming the slits 17, for example, an imprinting method is given.

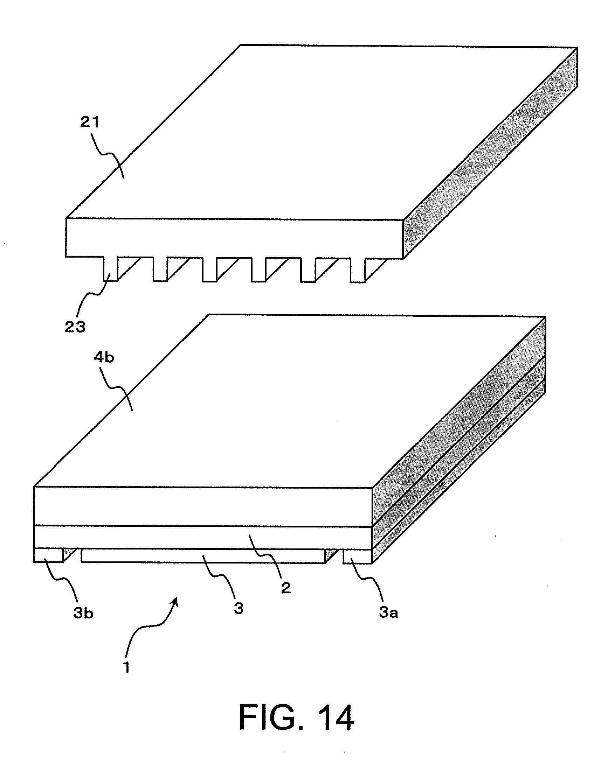

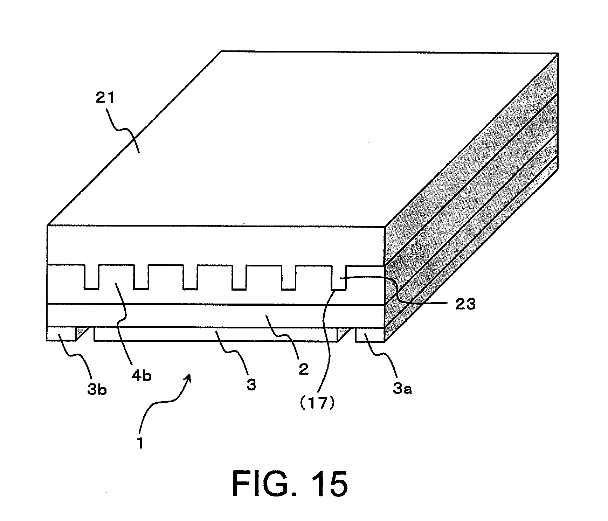

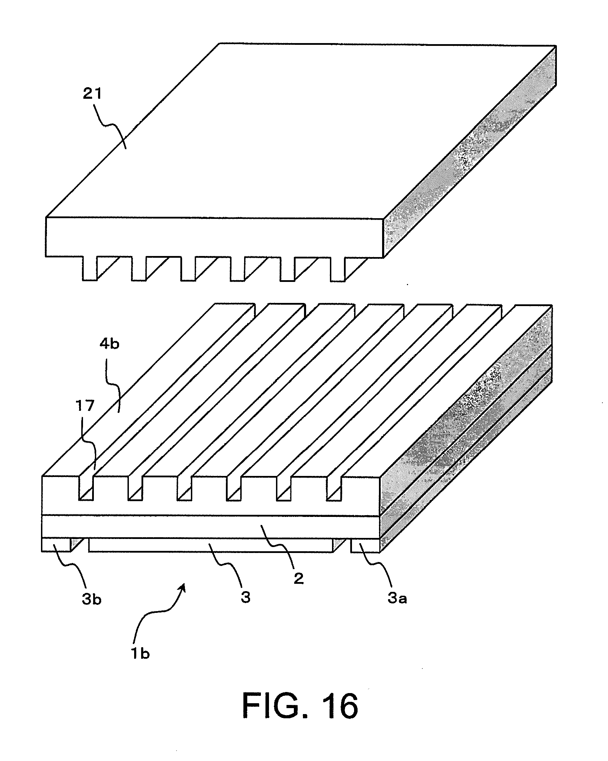

Specifically, before the formation of the slits 17, the substrate 4b is placed in a state in which the substrate is easily processed by heating, ultrasonic irradiation, UV irradiation, or the like in advance as needed. A template 21 having convex shapes 23 obtained by reversing the slits 17 as illustrated in Fig. 14 is pressed against the substrate 4b so as to form the slits 17 as illustrated in Fig. 15. Thereafter, as illustrated in Fig. 16, the template 21 is removed from the substrate 4b to manufacture the substrate 4b having the anisotropy in the thermal conduction characteristics.

As described above, according to the third embodiment, the thermoelectric conversion element 1b includes the substrate 4b, the magnetic film 2 provided on the substrate 4b and formed of the polycrystalline magnetic insulator material which can be magnetized in the predetermined direction, and the electrodes 3, 3a, and 3b provided on the magnetic film 2 and made of the material having the spin orbit interaction, and is configured to be capable of outputting the temperature gradient in the direction perpendicular to plane in the magnetic film 2 as the potential difference in the surface of the electrode 3 and the temperature gradient in the in-plane direction in the magnetic film 2 as the potential differences in the surfaces of the electrodes 3a and 3b.

Therefore, the same effects as those of the first embodiment are provided.

Moreover, according to the third embodiment, in the thermoelectric conversion element 1b, the substrate 4b has the slits 17 for blocking thermal conduction at least in one surface thereof, and therefore has the thermal conduction anisotropy.

Therefore, as compared with the first embodiment, the thermoelectric conversion with higher efficiency is enabled.

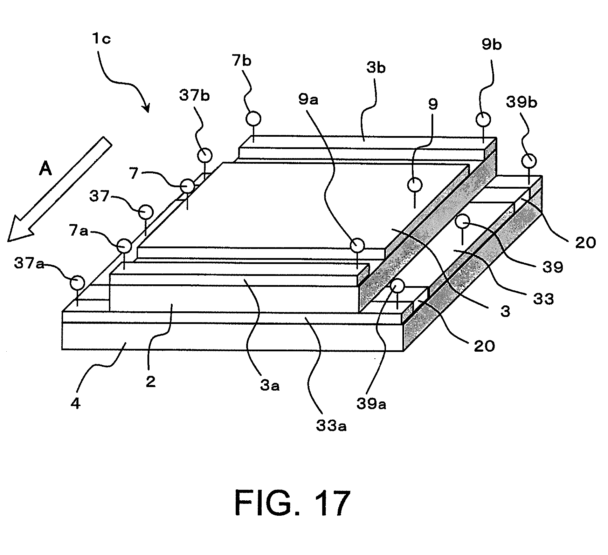

Next, a fourth embodiment of this invention is described referring to Figs. 17 to 21.

The fourth embodiment corresponds to a variation of the first embodiment in which electrodes are provided on both surfaces of the magnetic film 2.

In the fourth embodiment, the elements having the same functions as those of the first embodiment are denoted by the same reference symbols. Therefore, differences from the first embodiment are mainly described.

As illustrated in Fig. 17, a thermoelectric conversion element 1c according to the fourth embodiment includes electrodes 33, 33a, and 33b provided between the substrate 4 and the magnetic film 2.

The electrodes 33, 33a, and 33b have shapes respectively corresponding to those of the electrodes 3, 3a, and 3b, and are provided so as to correspond to the electrodes 3, 3a, and 3b in terms of a positional relation on the plane.

Specifically, the electrodes 33, 33a, and 33b are formed on the substrate 4 so as to be opposed to the electrodes 3, 3a, and 3b, respectively, across the magnetic film 2.

Similarly to the electrode 3, terminals 37 and 39 are formed removably on both ends of the electrode 33. Similarly, terminals 37a and 39a are formed removably on both ends of the electrode 33a, whereas terminals 37b and 39b are formed removably on both ends of the electrode 33b.

Moreover, spacers 20 are provided between the electrodes 33 and 33a and between the electrodes 33 and 33b.

The spacers 20 serve to electrically and magnetically isolate the electrodes from each other. For example, a non-magnetic insulator such as SiO₂ can be used. Further, if polyolefin such as polyethylene or polypropylene or polyester such as PET or PEN is used, the spacers 20 can be formed by a printing process.

The spacers 20 are portions which do not directly concern the thermoelectric conversion, and therefore are desirably as thin as possible.

In view of optimization of the thermoelectric conversion in the in-plane direction and the direction perpendicular to plane, it is preferred that the spacers 20 have a higher thermal conduction characteristic in the perpendicular direction than that in the horizontal direction. In particular, it is more preferred that the spacers have a higher thermal conductivity in the perpendicular direction and a lower thermal conductivity in the horizontal direction as compared with the magnetic film 2.

As described above, the electrodes may be provided not only on one surface of the magnetic film 2 but also on both surfaces thereof. In this manner, as compared with the case where the electrodes are provided only on one surface, the thermoelectromotive force can be more efficiently extracted from the spin current.

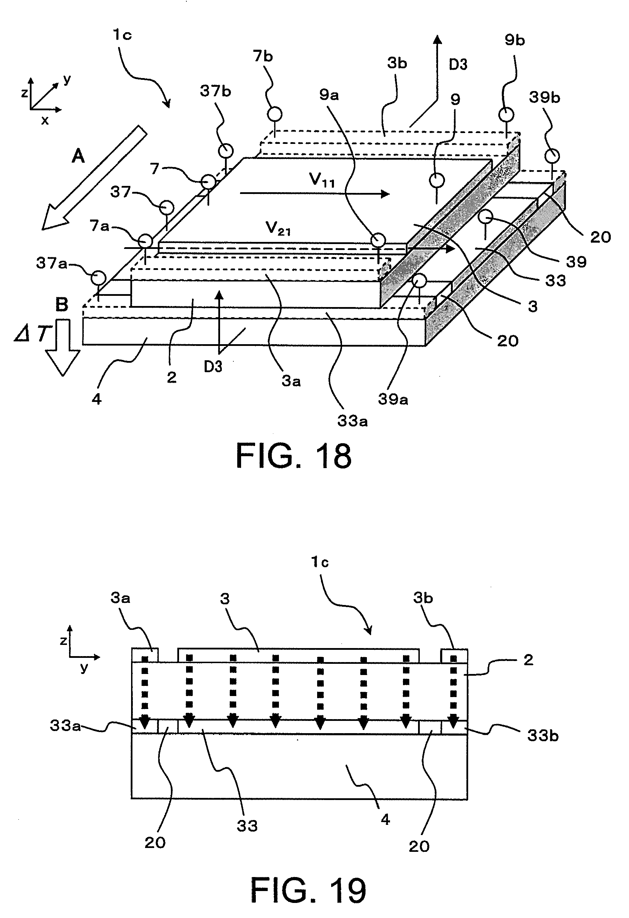

For example, as illustrated in Figs. 18 and 19, when the temperature gradient is applied in the direction perpendicular to an element surface of the thermoelectric conversion element 1c, the spin current is generated in the direction perpendicular to plane in the magnetic film 2 and then flows into the upper electrode 3 and the lower electrode 33. Thereafter, by the inverse spin-hall effect generated in the electrodes 3 and 33, the spin current is converted into a current in the direction perpendicular to the magnetization direction of the magnetic film 2. As a result, the potential difference between the terminals 7 and 9 can be extracted as the thermoelectromotive force V₁₁, whereas the potential difference between the terminals 37 and 39 can be extracted as a thermoelectromotive force V₂₁. The direction of the flow of the spin current is the same in the electrodes 3 and 33, and therefore the electromotive forces are generated in the same direction.

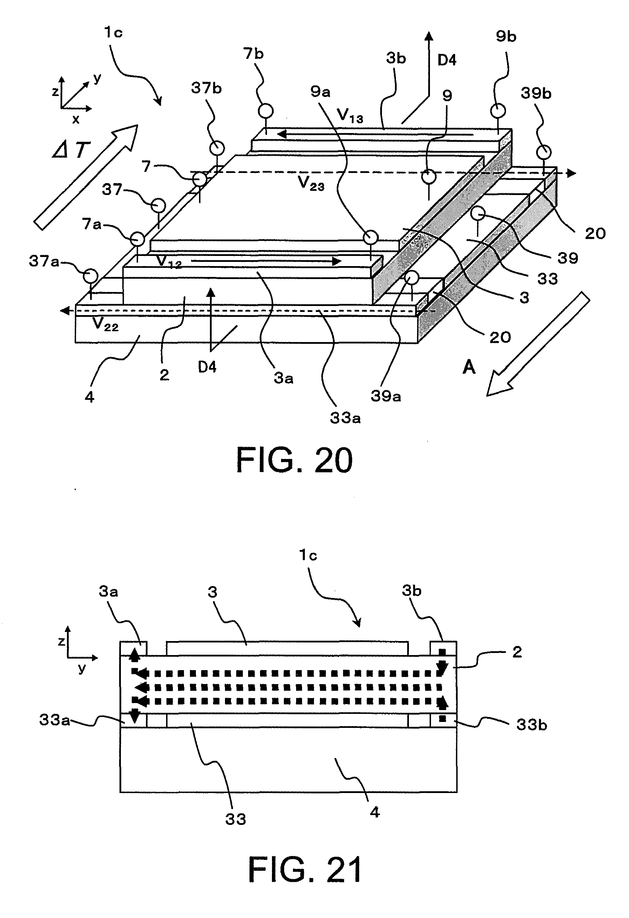

On the other hand, when the temperature gradient is applied in the direction parallel to the element surface of the thermoelectric conversion element 1c (front-back direction in the drawing) as illustrated in Figs. 20 and 21, the spin current is generated in the in-plane direction in the magnetic film 2 and mainly flows into the electrodes 3a, 33a, 3b, and 33b. By the inverse spin-hall effects in the electrodes 3a, 33a, 3b, and 33b, the spin current is converted into a current in the direction perpendicular to the magnetization direction of the magnetic film 2. As a result, the potential difference between the terminals 7a and 9a can be extracted as the thermoelectromotive force V₁₂, the potential difference between the terminals 7b and 9b can be extracted as the thermoelectromotive force V₁₃, a potential difference between the terminals 37a and 39a can be extracted as a thermoelectromotive force V₂₂, and a potential difference between the terminals 37b and 39b can be extracted as a thermoelectromotive force V₂₃.

As described above, according to the fourth embodiment, the thermoelectric conversion element 1c includes the substrate 4, the magnetic film 2 provided on the substrate 4 and formed of the polycrystalline magnetic insulator material which can be magnetized in the predetermined direction, and the electrodes 3, 3a, and 3b provided on the magnetic film 2 and made of the material having the spin orbit interaction, and is configured to be capable of outputting the temperature gradient in the direction perpendicular to plane in the magnetic film 2 as the potential difference in the surface of the electrode 3 and the temperature gradient in the in-plane direction in the magnetic film 2 as the potential differences in the surfaces of the electrodes 3a and 3b.

Therefore, the same effects as those of the first embodiment are provided.

According to the fourth embodiment, the electrodes are provided on both surfaces of the magnetic film 2 in the thermoelectric conversion element 1c.

Therefore, as compared with the first embodiment, the thermoelectromotive force can be more efficiently extracted from the spin current.

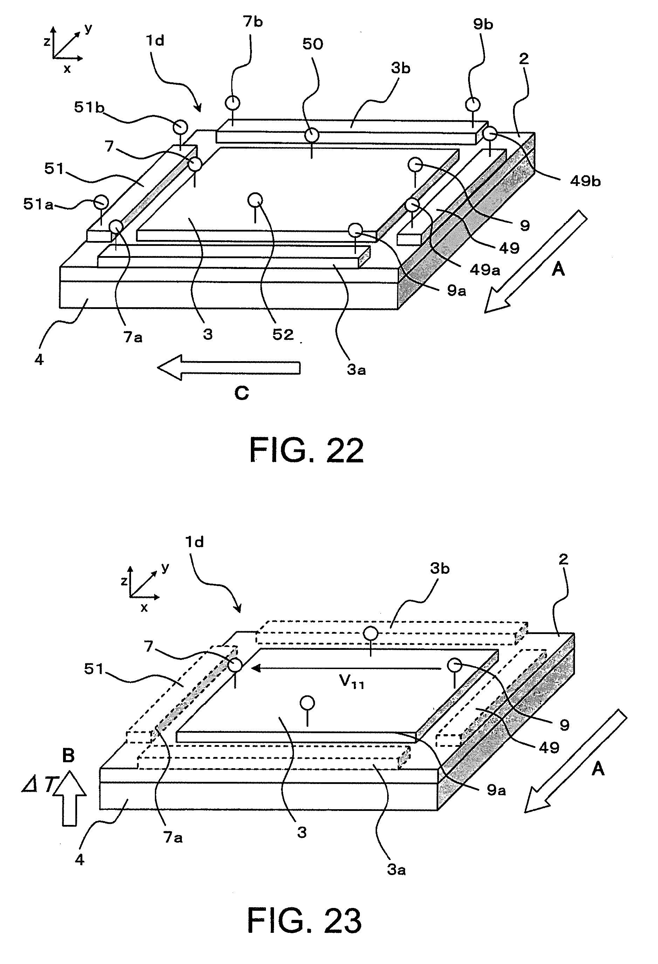

Next, a fifth embodiment of this invention is described referring to Figs. 22 to 26.

The fifth embodiment corresponds to a variation of the first embodiment in which electrodes 49 and 51 (end electrodes) are further provided on right and left ends of the magnetic film 2.

In the fifth embodiment, the elements having the same functions as those of the first embodiment are denoted by the same reference symbols. Therefore, differences from the first embodiment are mainly described.

As illustrated in Fig. 22, a thermoelectric conversion element 1d according to the fifth embodiment includes the electrodes 51 and 49 on the left and right ends of the magnetic film 2 across the electrode 3. Terminals 49a and 49b are formed removably on both ends of the electrode 49, whereas terminals 51a and 51b are formed removably on both ends of the electrode 51.

The electrodes 51 and 49 are provided so that opposed surfaces thereof cross (perpendicularly cross in this case) those of the electrodes 3a and 3b.

In Fig. 22, terminals 50 and 52 are formed removably even on upper and lower ends of the electrode 3.

As described above, the number of the pair of end electrodes provided on the ends is not limited to one but may also be two. In this manner, as compared with the case where only one pair thereof is provided, the thermoelectromotive force can be more efficiently extracted by the temperature gradient in the in-plane direction.

An example of a specific operation when the temperature gradient is applied to the thermoelectric conversion element 1d is described referring to Figs. 23 to 26.

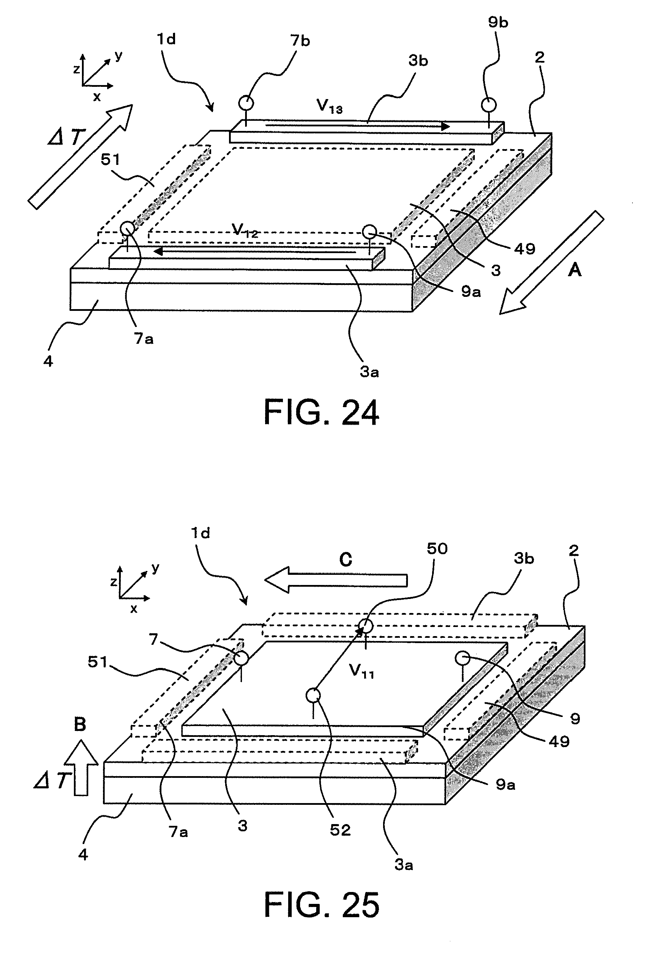

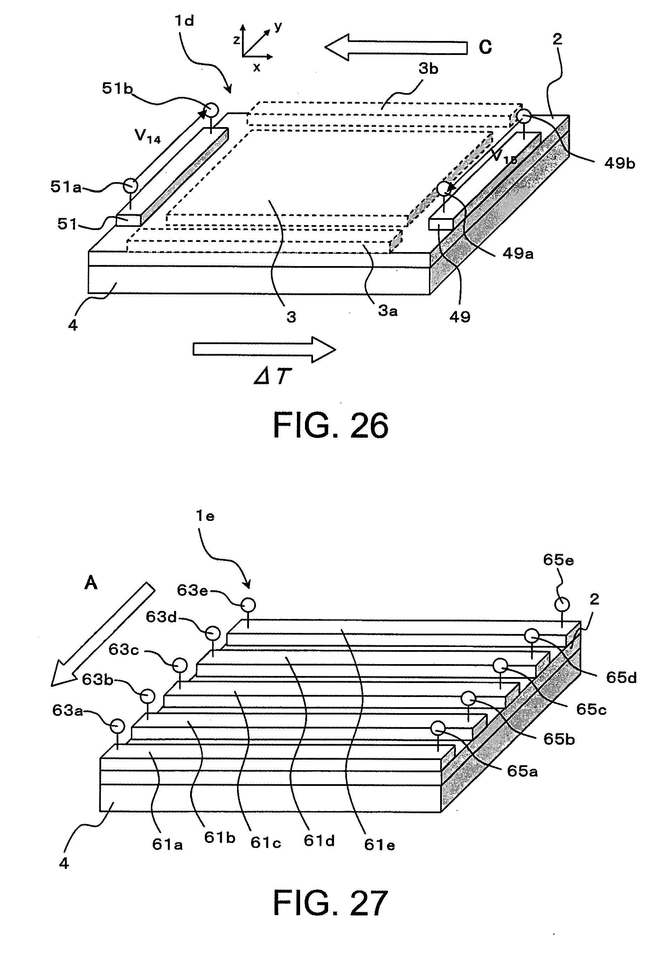

It is supposed that the magnetization direction is fixed in advance to a -y-direction (direction indicated by the outlined arrow A in Figs. 23 and 24) when the thermoelectric power generation is performed by a temperature gradient in a y-x in-plane direction and to a -x-direction (direction indicated by the outlined arrow C in Figs. 25 and 26) when the thermoelectric power generation is performed by a temperature gradient in an x-z in-plane direction.

First, when the temperature gradient is applied in a direction perpendicular to the element surface (z-direction in the drawing) as illustrated in Fig. 23 in the arrangement in which the magnetization direction is fixed to the -y-direction, the spin current generated in the direction perpendicular to plane in the magnetic film 2 mainly flows to the electrode 3. Thereafter, by the inverse spin-hall effect in the electrode 3, the spin current is converted into a current in a direction perpendicular to the magnetization direction of the magnetic film 2. As a result, the potential difference between the terminals 7 and 9 can be extracted as the thermoelectromotive force V₁₁.

Similarly, as illustrated in Fig. 24, when the temperature gradient is applied to the front-back direction parallel to the element surface (y-direction in the drawing), the spin current generated in the in-plane direction in the magnetic film 2 mainly flows to the electrodes 3a and 3b. Thereafter, by the inverse spin-hall effect in the electrodes 3a and 3b, the spin current is converted into a current in the direction perpendicular to the magnetization direction of the magnetic film 2. As a result, the potential difference between the terminals 7a and 9a can be extracted as the thermoelectromotive force V₁₂, whereas the potential difference between the terminals 7b and 9b can be extracted as the thermoelectromotive force V₁₃. The direction of the flow of the spin current at the interface with the magnetic film 2 is different between the electrodes 3a and 3b, and therefore the electromotive forces are generated in directions antiparallel to each other.

The case with the temperature gradient in the z-direction is illustrated in Fig. 23, and the case with the temperature gradient in the y-direction is illustrated in Fig. 24. However, even in an intermediate case therebetween, that is, even for any temperature gradient in the y-z plane, the thermoelectromotive forces can be extracted from the plurality of electrodes 3, 3a, and 3b with high efficiency.

Next, as illustrated in Fig. 25, when the temperature gradient is applied in a direction perpendicular to the element surface (z-direction in the drawing) in the arrangement in which the magnetization direction is fixed to the -x-direction, the spin current generated in the direction perpendicular to plane in the magnetic film 2 mainly flows to the electrode 3. Thereafter, by the inverse spin-hall effect in the electrode 3, the spin current is converted into a current in a direction perpendicular to the magnetization direction of the magnetic film 2. As a result, the potential difference between the terminals 50 and 52 can be extracted as the thermoelectromotive force V₁₁.

On the other hand, as illustrated in Fig. 26, when the temperature gradient is applied to the left-right direction parallel to the element surface (x-direction in the drawing), the spin current generated in the in-plane direction in the magnetic film 2 mainly flows to the electrodes 49 and 51. Thereafter, by the inverse spin-hall effect in the electrodes 49 and 51, the spin current is converted into a current in the direction perpendicular to the magnetization direction of the magnetic film 2. As a result, the potential difference between the terminals 51a and 51b can be extracted as a thermoelectromotive force V₁₄, whereas the potential difference between the terminals 49a and 49b can be extracted as a thermoelectromotive force V₁₅. The direction of the flow of the spin current at the interface with the magnetic film 2 is different between the electrodes 49 and 51, and therefore the electromotive forces are generated in directions antiparallel to each other.

The case with the temperature gradient in the z-direction is illustrated in Fig. 25, and the case with the temperature gradient in the x-direction is illustrated in Fig. 26. However, even in an intermediate case therebetween, that is, even for any temperature gradient in the x-z plane, the thermoelectromotive forces can be extracted from the plurality of electrodes 3, 49, and 51 with high efficiency.

The power-generating operation when the magnetization direction is fixed to the -y-direction or the -x-direction has been described referring to Figs. 23 to 26. Moreover in an intermediate case therebetween, that is, in the case where the magnetization direction is fixed to a direction at 45 degrees with respect to the x-y plane, the thermoelectric conversion is enabled for the temperature gradient in any of three directions, that is, the x-direction, the y-direction, and the z-direction.

As described above, by optimizing the direction of magnetization by an external magnetic field or the like in advance in accordance with the direction of the temperature gradient to be applied so that a sum total of the thermoelectromotive forces generated by the plurality of electrodes becomes maximum, the thermoelectric conversion with high efficiency is enabled for any temperature gradient. Moreover, if a magnetic material having a coercive force is used for the magnetic film 2, a thermoelectric conversion element which is optimally initialized in accordance with a purpose of use can be provided because the thermoelectric conversion element can be operated even under a zero magnetic field after the magnetization direction is once initialized by the external magnetic field or the like.

As described above, according to the fifth embodiment, the thermoelectric conversion element 1d includes the substrate 4, the magnetic film 2 provided on the substrate 4 and formed of the polycrystalline magnetic insulator material which can be magnetized in the predetermined direction, and the electrodes 3, 3a, and 3b provided on the magnetic film 2 and made of the material having the spin orbit interaction, and is configured to be capable of outputting the temperature gradient in the direction perpendicular to plane in the magnetic film 2 as the potential difference in the surface of the electrode 3 and the temperature gradient in the in-plane direction in the magnetic film 2 as the potential differences in the surfaces of the electrodes 3a and 3b.

Therefore, the same effects as those of the first embodiment are provided.

According to the fifth embodiment, the thermoelectric conversion element 1d includes the electrodes 49 and 51 on the right and left ends of the magnetic film 2.

Therefore, as compared with the first embodiment, the thermoelectromotive force can be more efficiently extracted by the temperature gradient in the in-plane direction.

Next, a sixth embodiment of this invention is described referring to Figs. 27 to 34.

The sixth embodiment corresponds to a variation of the first embodiment in which a plurality of strip-like electrodes are provided and the electrodes are connected in accordance with the direction of the temperature gradient to obtain the thermoelectromotive force.

In the sixth embodiment, the elements having the same functions as those of the first embodiment are denoted by the same reference symbols. Therefore, differences from the first embodiment are mainly described.

First, referring to Fig. 27, a structure of a thermoelectric conversion element 1e according to the sixth embodiment is described.

As illustrated in Fig. 27, the thermoelectric conversion element 1e includes stripe-like electrodes 61a, 61b, 61c, 61d, and 61e which have a longitudinal direction in a direction perpendicular to the magnetization direction A of the magnetic film 2 and are arranged so as to be parallel to each other.

Terminals 63a and 65a are formed removably on both ends of the electrode 61a in the longitudinal direction, terminals 63b and 65b are formed removably on both ends of the electrode 61b in the longitudinal direction, and terminals 63c and 65c are formed removably on both ends of the electrode 61c in the longitudinal direction.

Moreover, terminals 63d and 65d are formed removably on both ends of the electrode 61d in the longitudinal direction, and terminals 63e and 65e are formed removably on both ends of the electrode 61e in the longitudinal direction.

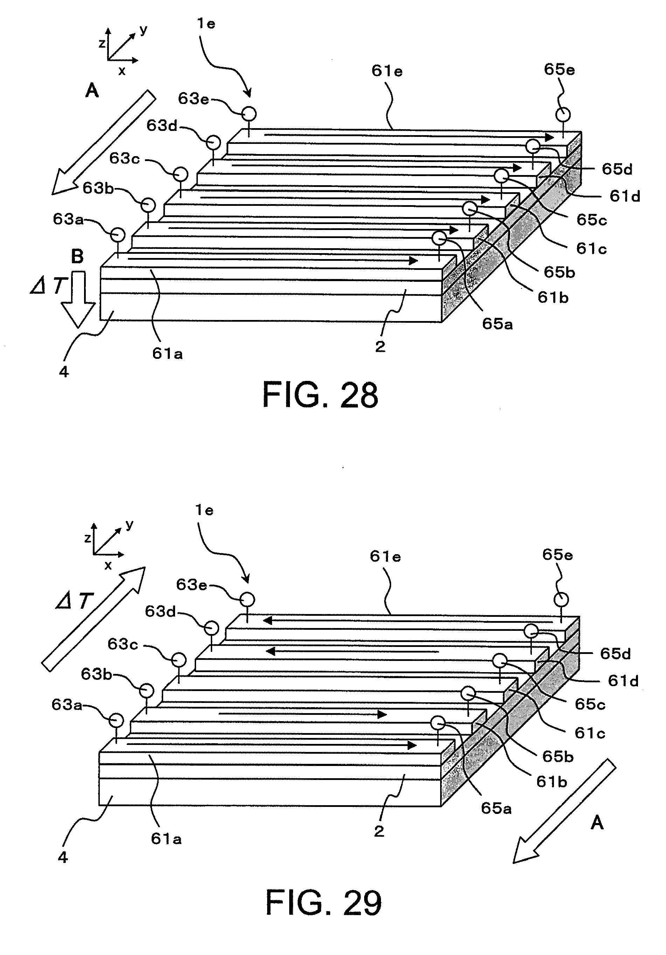

Next, a specific example of operation when the temperature gradient is applied to the thermoelectric conversion element 1e is described referring to Figs. 28 to 31.

First, as illustrated in Fig. 28, when the temperature gradient is applied in the direction perpendicular to an element surface of the thermoelectric conversion element 1e (direction perpendicular to plane), the spin current generated in the direction perpendicular to plane in the magnetic film 2 flows to the electrodes 61a, 61b, 61c, 61d, and 61e. By the inverse spin-hall effect generated in each of the electrodes, the spin current is generated and is then converted into a current (electromotive force) in the direction perpendicular to the magnetization direction of the magnetic film 2 to be extracted as the thermoelectromotive force.

On the other hand, as illustrated in Fig. 29, when the temperature gradient is applied in the direction parallel to the element surface of the thermoelectric conversion element 1e (front-back direction in the drawing), the spin current generated in the in-plane direction in the magnetic film 2 flows to the electrodes 61a, 61b, 61d, and 61e. Thereafter, by the inverse spin-hall effect generated in the electrodes, the spin current is converted into a current (electromotive force) in the direction perpendicular to the magnetization direction of the magnetic film 2 to be extracted as the thermoelectromotive force. In this case, however, the spin currents are generated in the magnetic film 2 in the front-back direction in the drawing. Therefore, the direction of the spin current (sign of the spin current) at the interface between each of the electrodes and the magnetic film 2 in the electrodes 61a and 61b which are provided on the front side of the magnetic film 2 becomes opposite (has the opposite sign) to that in the electrodes 61d and 61e which are provided on the back side of the magnetic film 2. Therefore, the direction of generation of the thermoelectromotive force in the electrodes 61a and 61b becomes opposite (has the opposite sign) to that in the electrodes 61d and 61e.

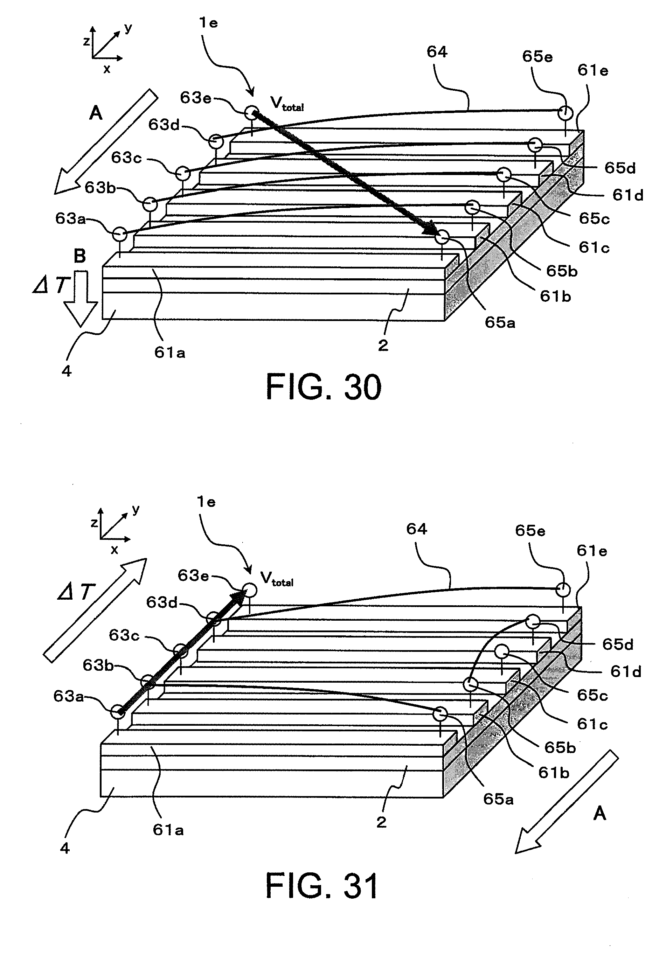

Moreover, when the thermoelectromotive forces generated in the plurality of electrodes are added by electric series connection, a large output voltage can be obtained as a whole. Each of Figs. 30 and 31 illustrates a structure in which the electrodes are connected to each other by connection lines 64 as an example. Fig. 30 illustrates an optimal connection structure with the connection lines 64 when the temperature gradient in the direction perpendicular to plane is applied, and Fig. 31 illustrates an optimal connection structure with the connection lines 64 when the temperature gradient in the in-plane direction is applied.

As illustrated in Figs. 30 and 31, a mode of connection of the electrodes for effectively adding the thermoelectromotive forces differs between the case where the temperature gradient in the direction perpendicular to plane is used and the case where the temperature gradient in the in-plane direction is used. Therefore, it is desirable that the mode of series connection of the electrodes by the connection lines 64 be reconfigurable in accordance with the direction of the temperature gradient.

By the configurations described above, as in the case of the first embodiment, a thermoelectric power-generating function by the temperature gradients in the direction perpendicular to plane and in the in-plane direction is realized.

The reason why the electrodes 61a, 61b, 61c, 61d, and 61e are formed to have the strip-like shape as illustrated in Fig. 27 is described.

As described above, for the highly efficient thermoelectric power generation, it is desirable for the thermoelectric conversion element to have an element structure having a small thermal conduction (a short thermal conduction path) so as to maintain a temperature difference to be applied for continuous power generation. On the other hand, in order to obtain larger electric power by the temperature gradient in the direction perpendicular to plane, it is desirable that an area of the electrode be larger as in the case of the electrode 3 of the first embodiment. Under conditions where in-plane thermoelectric power generation is performed in a structure in which the electrode 3 having a large area is disposed as in the case of the first embodiment, however, a large heat flow flows in the plane of the electrode 3, resulting in an increase in the heat conduction (generation of a long thermal conduction path) in the in-plane direction as the whole element, in particular, when the electrode 3 has large film thickness and thermal conductivity. In this case, there is a possibility that the thermoelectric power generation efficiency for the temperature gradient in the in-plane direction becomes lower than that obtained by the method with the temperature gradient in the direction perpendicular to plane.

On the other hand, in the thermoelectric conversion element 1d as illustrated in Fig. 27, the plurality of strip-like electrodes are disposed so as to be separated away from each other. Hence, a long thermal conduction path in the electrode portion is not generated. Therefore, the above-mentioned problem is solved.

Further, by connecting the plurality of electrodes as illustrated in Figs. 30 and 31, the same effects as those obtained when the area of the electrode is effectively increased are obtained. Specifically, the thermal conduction in the plane can be reduced, while large electric power can be obtained by the temperature gradient in the direction perpendicular to plane at the same time.

The number of electrodes is preferably even. This is because, if the number of electrodes is odd, electric power cannot be obtained from the electrode disposed in the center (electrode 61c in the case illustrated in Fig. 27) when the temperature gradient in the in-plane direction is applied.

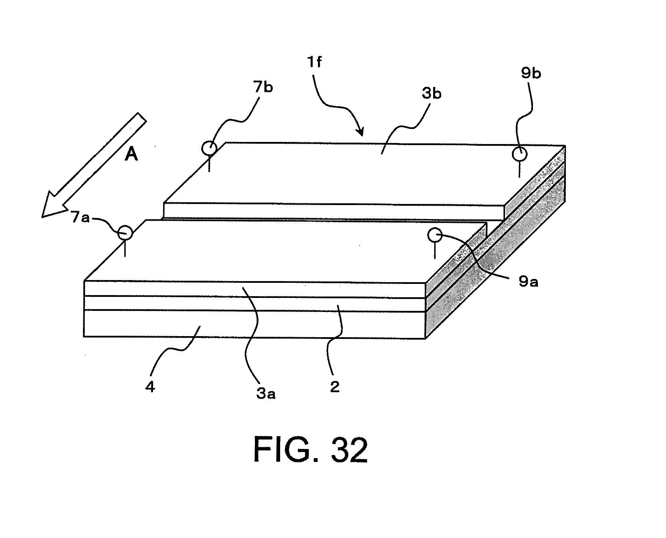

Moreover, Fig. 27 illustrates the structure in which the five electrodes are arranged in parallel. However, the number of electrodes may be at least two. Therefore, the same effects are expected to be obtained even by a structure including only two electrodes (electrodes 3a and 3b) as in the case of a thermoelectric conversion element 1f illustrated in Fig. 32.

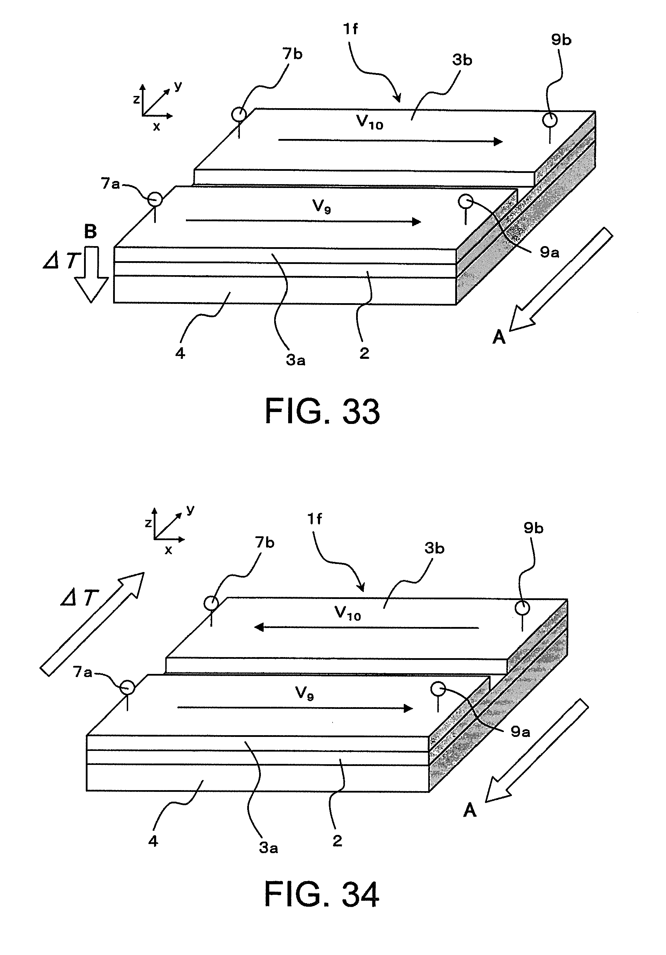

That is, as illustrated in Fig. 33, when the temperature gradient is applied to the direction perpendicular to an element surface of the thermoelectric conversion element If, the spin current generated in the direction perpendicular to plane in the magnetic film 2 flows to the electrodes 3a and 3b. By the inverse spin-hall effect generated in each of the electrodes, the spin current is generated and is then converted into a current (electromotive force) in the direction perpendicular to the magnetization direction of the magnetic film 2. As a result, the potential difference between the terminals 7a and 9a can be extracted as a thermoelectromotive force V₉, whereas the potential difference between the terminals 7b and 9b can be extracted as a thermoelectromotive force V₁₀.

Moreover, as illustrated in Fig. 34, when the temperature gradient is applied to the direction parallel to the element surface of the thermoelectric conversion element 1f (front-back direction in the drawing), the spin current generated in the in-plane direction in the magnetic film 2 flows to the electrodes 3a and 3b. Thereafter, by the inverse spin-hall effect generated in the electrodes 3a and 3b, the spin current is converted into a current (electromotive force) in the direction perpendicular to the magnetization direction of the magnetic film 2. As a result, the potential difference between the terminals 7a and 9a can be extracted as the thermoelectromotive force V₉, whereas the potential difference between the terminals 7b and 9b can be extracted as the thermoelectromotive force V₁₀. In this case, however, the spin currents are generated in the magnetic film 2 in the front-back direction in the drawing. Therefore, the direction of the flow of the spin current (sign of the spin current) at the interface between each of the electrodes and the magnetic film 2 in the electrode 3a which is provided on the front side of the magnetic film 2 becomes opposite (has the opposite sign) to that in the electrode 3b which is provided on the back side of the magnetic film 2.

As described above, according to the sixth embodiment, the thermoelectric conversion element 1e includes the substrate 4, the magnetic film 2 provided on the substrate 4 and formed of the polycrystalline magnetic insulator material which can be magnetized in the predetermined direction, and the electrodes 61a, 61b, 61c, 61d, and 61e provided on the magnetic film 2 and made of the material having the spin orbit interaction, and is configured to be capable of outputting the temperature gradient in the direction perpendicular to plane in the magnetic film 2 and the temperature gradient in the in-plane direction in the magnetic film 2 as the potential differences in the surfaces of the electrodes 61a, 61b, 61c, 61d, and 61e.

Thus, the same effects as those of the first embodiment are provided.

Moreover, according to the sixth embodiment, the thermoelectric conversion element 1e includes the strip-like electrodes 61a, 61b, 61c, 61d, and 61e, which have the longitudinal direction in the direction perpendicular to the magnetization direction of the magnetic film 2 and are arranged in parallel to each other.

Therefore, as compared with the first embodiment, the thermal conduction in the plane is reduced, while large electric power is obtained by the temperature gradient in the direction perpendicular to plane at the same time. Accordingly, highly efficient thermoelectric conversion for any of the temperature gradient in the direction perpendicular to plane and the temperature gradient in the in-plane direction can be performed.

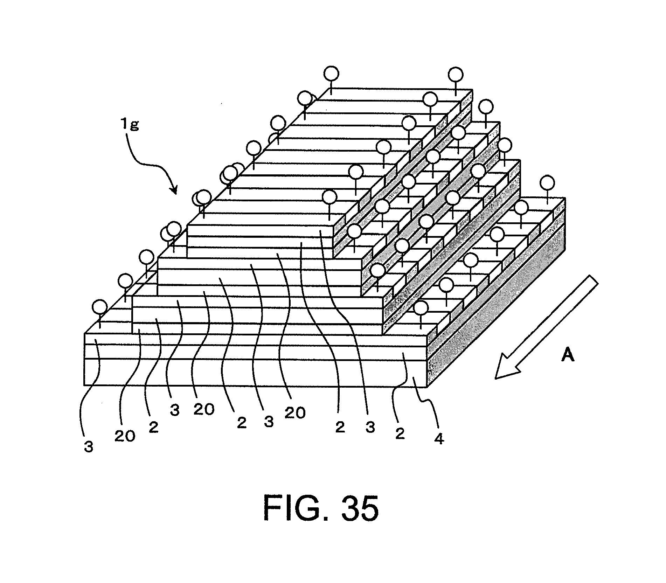

Next, a seventh embodiment of this invention is described referring to Figs. 35 to 37.

The seventh embodiment corresponds to a variation of the sixth embodiment in which the magnetic films 2 and the electrodes 3 are laminated.

In the seventh embodiment, the elements having the same functions as those of the sixth embodiment are denoted by the same reference symbols. Therefore, differences from the sixth embodiment are mainly described.

As illustrated in Fig. 35, a thermoelectric conversion element 1g according to the seventh embodiment has a structure in which the magnetic films 2 and the electrodes 3 are alternately laminated. The spacer 20 is provided between a lower surface of each of the magnetic films 2 and an upper surface of each of the electrodes 4.

When the temperature gradient is applied to the magnetic substance described above, the spin current is induced in the direction of the temperature gradient by the spin-Seebeck effect.

In the thermoelectric conversion element 1g, the spin currents are respectively generated by the temperature gradient in the plurality of laminated magnetic films 2. In order to extract the spin currents as the electromotive forces, the plurality of electrodes 3 are respectively disposed on the plurality of magnetic films 2 so as to be parallel to each other in this embodiment. By the electrodes, the spin currents in any direction in the magnetic substance can be extracted as the electromotive forces.

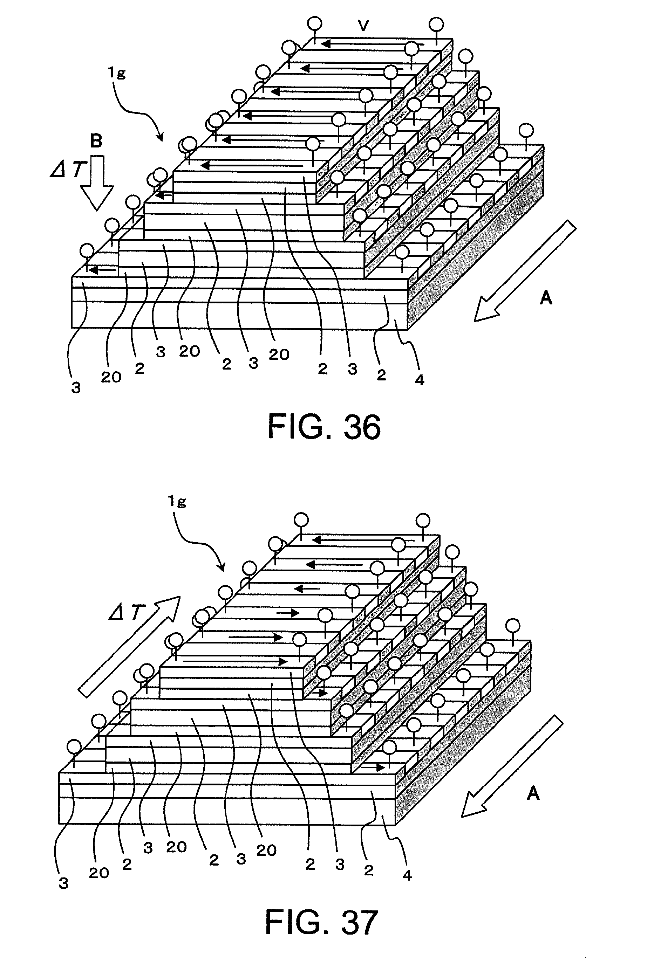

A specific example of operation when the temperature gradient is applied to the thermoelectric conversion element If is described referring to Figs. 36 and 37.

First, as illustrated in Fig. 36, when the temperature gradient is applied to the direction perpendicular to an element surface of the thermoelectric conversion element Ig (direction perpendicular to plane), the spin current generated in the direction perpendicular to plane in each of the magnetic films 2 flows to each of the electrodes 3 adjacent thereto. By the inverse spin-hall effect generated in each of the electrodes 3, the spin current is converted into a current (electromotive force) in the direction perpendicular to the magnetization direction of the magnetic film 2 to be extracted as the thermoelectromotive force V.

On the other hand, as illustrated in Fig. 37, when the temperature gradient is applied to the direction parallel to the element surface of the thermoelectric conversion element 1g (in-plane direction), the spin current is generated in the in-plane direction in each of the magnetic films 2 and then flows into each of the electrodes 3 adjacent thereto. By the inverse spin-hall effect generated in each of the electrodes 3, the spin current is converted into a current (electromotive force) in the direction perpendicular to the magnetization direction of the magnetic film 2 to be extracted as the thermoelectromotive force V.

As described above, the thermoelectric conversion element can be configured to have a laminate structure. The thermoelectromotive forces can be respectively extracted by the plurality of laminated electrodes 3. In this manner, the thermoelectric conversion element having a large power generation efficiency as a whole can be realized for any of the temperature gradient in the direction perpendicular to plane and the in-plane direction.

As described above, according to the seventh embodiment, the thermoelectric conversion element 1g includes the substrate 4, the magnetic film 2 provided on the substrate 4 and formed of the polycrystalline magnetic insulator material which can be magnetized in the predetermined direction, and the electrodes 3 provided on the magnetic film 2 and made of the material having the spin orbit interaction, and is configured to be capable of outputting the temperature gradient in the direction perpendicular to plane in the magnetic film 2 as the potential difference in the surface of the electrode 3 and the temperature gradient in the in-plane direction in the magnetic film 2 as the potential difference in the surface of the electrode 3.

Therefore, the same effects as those of the first embodiment are provided.

Further, according to the seventh embodiment, the thermoelectric conversion element 1g has the structure in which the magnetic films 2 and the electrodes 3 are alternatively laminated.

Therefore, as compared with the case with a single layer, a larger thermoelectromotive force can be obtained.

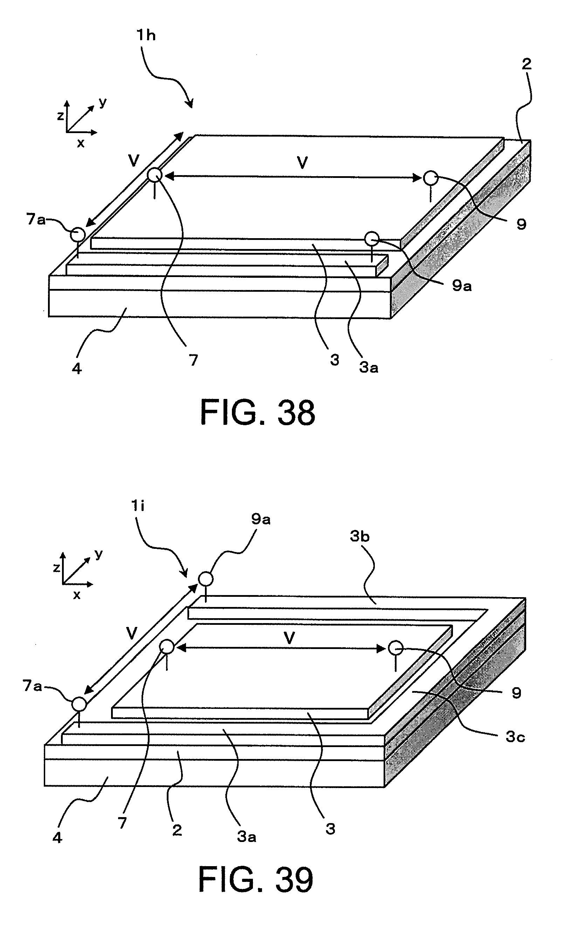

Next, an eighth embodiment of this invention is described referring to Fig. 38.

The eighth embodiment corresponds to a variation of the first embodiment in which only one end electrode is provided.

In the eighth embodiment, the elements having the same functions as those of the first embodiment are denoted by the same reference symbols. Therefore, differences from the first embodiment are mainly described.

As illustrated in Fig. 38, a thermoelectric conversion element 1h according to the eighth embodiment includes only one end electrode (electrode 3a).

As described above, the end electrode is not necessarily required to be provided in pair, and may be provided on only one end of the magnetic film 2.

As described above, according to the eighth embodiment, the thermoelectric conversion element 1h includes the substrate 4, the magnetic film 2 provided on the substrate 4 and formed of the polycrystalline magnetic insulator material which can be magnetized in the predetermined direction, and the electrodes 3 and 3a provided on the magnetic film 2 and made of the material having the spin orbit interaction, and is configured to be capable of outputting the temperature gradient in the direction perpendicular to plane in the magnetic film 2 as the potential difference in the surface of the electrode 3 and the temperature gradient in the in-plane direction in the magnetic film 2 as the potential differences in the surfaces of the electrodes 3 and 3a.

Therefore, the same effects as those of the first embodiment are provided.

Next, a ninth embodiment of this invention is described referring to Fig. 39.

The ninth embodiment corresponds to a variation of the first embodiment in which the electrodes 3a and 3b are integrated into one body.

In the ninth embodiment, the elements having the same functions as those of the first embodiment are denoted by the same reference symbols. Therefore, differences from the first embodiment are mainly described.

As illustrated in Fig. 39, in a thermoelectric conversion element 1i according to the ninth embodiment, the electrodes 3a and 3b are connected by a connection portion 3c to configure an integrated U-like shaped end electrode.

As described above, the end electrodes are not necessarily required to be provided in pair and separated away from each other, but may also be connected to each other.

As described above, according to the ninth embodiment, the thermoelectric conversion element 1i includes the substrate 4, the magnetic film 2 provided on the substrate 4 and formed of the polycrystalline magnetic insulator material which can be magnetized in the predetermined direction, and the electrodes 3, 3a, and 3b provided on the magnetic film 2 and made of the material having the spin orbit interaction, and is configured to be capable of outputting the temperature gradient in the direction perpendicular to plane in the magnetic film 2 as the potential difference in the surface of the electrode 3 and the temperature gradient in the in-plane direction in the magnetic film 2 as the potential differences in the surfaces of the electrodes 3a and 3b.

Therefore, the same effects as those of the first embodiment are provided.

### <Examples>

In the following, this invention is described further in detail based on examples.

### [Example 1]

The thermoelectric conversion element 1 according to the first embodiment was manufactured. A specific procedure was as follows.

First, as the substrate 4, a (111) plane of a gadolinium gallium garnet (hereinafter referred to as "GGG"; a composition thereof was Gd₃Ga₅O₁₂) substrate manufactured by Saint-Gobain K. K was used. As the magnetic film 2, an yttrium iron garnet film having a Y-site partially substituted by Bi (composition thereof was BiY₂Fe₅O₁₂; hereinafter referred to as "Bi:YIG") was used. For the electrodes 3, 3a, and 3b, Pt was used. In this case, a thickness of the GGG substrate was set to 0.7 mm, a thickness of the Bi:YIG film was set to 0.3 mm, and a thickness of the Pt electrode was set to 10 nm.

The Bi:YIG magnetic film 2 was formed by the aerosol deposition method. As a Bi:YIG raw material, Bi:YIG fine particles having a diameter of 300 nm were used. The Bi:YIG fine particles were stored in an aerosol generator container, and the GGG substrate was fixed to a holder provided in a film-formation chamber. By generating a pressure difference between the film-formation chamber and the aerosol generator container in this state, the Bi:YIG fine particles were drawn into the film-formation chamber and were sprayed onto the GGG substrate through a nozzle. By a collision energy generated at the substrate at this time, the fine particles were crushed and recombined to form YIG polycrystal on the substrate. A substrate stage was two-dimensionally scanned to form the uniform Bi:YIG magnetic film 2 to a film thickness of 0.3 mm on the substrate.

Further, after a surface of the thus formed Bi:YIG magnetic film 2 was polished, the Pt electrodes 3, 3a, and 3b were formed on the Bi:YIG magnetic film by photolithography and sputtering to complete the thermoelectric conversion element 1.

### [Example 2]

The thermoelectric conversion element 1a according to the second embodiment was manufactured. A specific procedure was as follows.

As the substrate 4a, a thermal conduction anisotropic substrate containing carbon fibers oriented in an epoxy resin as fillers was used. The carbon fibers were oriented in the direction perpendicular to plane with respect to the substrate, and had a high thermal conductivity in this direction.

As the magnetic film 2, a yttrium iron garnet film having a Y-site partially substituted by Bi (BiY₂Fe₅O₁₂) was used. For the electrodes 3, 3a, and 3b, Pt was used. In this case, a thickness of the substrate 4a was set to 0.3 mm, a thickness of the Bi:YIG film was set to 0.1 mm, and a thickness of the Pt electrode was set to 10 nm.

The Bi:YIG magnetic film 2 was formed by the aerosol deposition method. As a Bi:YIG raw material, Bi:YIG fine particles having a diameter of 300 nm were used. The Bi:YIG fine particles were stored in an aerosol generator container, and the substrate was fixed to a holder provided in a film-formation chamber. By generating a pressure difference between the film-formation chamber and the aerosol generator container in this state, the Bi:YIG fine particles were drawn into the film-formation chamber and were sprayed onto the substrate through a nozzle. By a collision energy generated at the substrate at this time, the fine particles were crushed and recombined to form YIG polycrystal on the substrate. A substrate stage was two-dimensionally scanned to form the uniform Bi:YIG magnetic film 2 to a film thickness of 0.1 mm on the substrate.

Further, after a surface of the thus formed Bi:YIG magnetic film 2 was polished, the Pt electrodes 3, 3a, and 3b were formed on the Bi:YIG magnetic film by photolithography and sputtering to complete the thermoelectric conversion element 1a.

### [Example 3]

The thermoelectric conversion element 1b according to the third embodiment was manufactured. A specific procedure was as follows.

As the substrate 4b having an anisotropic thermal conduction characteristic, a polyimide substrate having a thickness of 0.3 mm, with a back surface on which cuts, each having a width of 0.1 mm and a depth of 0.2 mm, were formed, was used.

As the magnetic film 2, a Bi:YIG film was used. For the electrodes 3, 3a, and 3b, Pt was used. In this case, a thickness of the Bi:YIG film was set to 0.1 mm and a thickness of the Pt electrode was set to 10 nm.

The Bi:YIG magnetic film 2 was formed by the aerosol deposition method. As a Bi:YIG raw material, Bi:YIG fine particles having a diameter of 300 nm were used. The Bi:YIG fine particles were stored in an aerosol generator container, and the substrate 4b was fixed to a holder provided in a film-formation chamber. By generating a pressure difference between the film-formation chamber and the aerosol generator container in this state, the Bi:YIG fine particles were drawn into the film-formation chamber and were sprayed onto the substrate 4b through a nozzle. By a collision energy generated at the substrate at this time, the fine particles were crushed and recombined to form YIG polycrystal on the substrate 4b. A substrate stage was two-dimensionally scanned to form the uniform Bi:YIG magnetic film 2 to a film thickness of 0.1 mm on the substrate 4b.

Further, after a surface of the thus formed Bi:YIG magnetic film 2 was polished, the Pt electrodes 3, 3a, and 3b were formed on the Bi:YIG magnetic film by photolithography and sputtering.

Finally, the back surface of the substrate 4b was processed by the imprinting method using the template 21 for forming cuts, as illustrated in Fig. 14. In this case, the substrate was heated in advance. Then, the template 21 was pressed against the substrate to form the cuts 7. Finally, the substrate 4b was cooled to manufacture the substrate 4b having anisotropy in the thermal conduction characteristics.

By the procedure described above, the thermoelectric conversion element 1b was completed.

### Industrial Applicability:

As an example of use of this invention, a power source for feeding power to a terminal, a sensor, or the like is given.

In the embodiments described above, the case where the thermoelectric conversion element is applied to the thermoelectric power generation for extracting the current or the voltage from the temperature gradient has been described. However, this invention is not limited thereto. For example, the thermoelectric conversion element can also be used for a thermal sensor for detecting a temperature (by providing an absorption film or the like in proximity), an infrared ray, or the like. Contrary to the way of use described above, the use as a Peltier device for generating the temperature gradient by the flow of the current from the exterior through the electrode is possible in principle.

This application claims priority from Japanese Patent Application No. 2011-114301, filed on May 23, 2011, the entire disclosure of which is incorporated herein by reference.

### Reference Signs List:

- 1: thermoelectric conversion element
- 1a: thermoelectric conversion element
- 1b: thermoelectric conversion element
- 1c: thermoelectric conversion element
- 1d: thermoelectric conversion element
- 1e: thermoelectric conversion element
- 1f: thermoelectric conversion element
- 1g: thermoelectric conversion element
- 1h: thermoelectric conversion element
- 1i: thermoelectric conversion element
- 2: magnetic film
- 3a: electrode
- 3b: electrode
- 3c: connection portion
- 4: substrate
- 4a: substrate
- 4b: substrate
- 6: substrate support
- 7: terminal
- 7a: terminal
- 7b: terminal
- 11: temperature-gradient application means
- 13: magnetization means
- 15: filler
- 17: slit
- 20: spacer
- 21: template
- 23: convex shape
- 33: electrode
- 33a: electrode
- 33b: electrode
- 37: terminal
- 37a: terminal
- 37b: terminal
- 49: electrode
- 49a: terminal
- 50: terminal
- 51: electrode
- 51a: terminal
- 61 a: electrode
- 61b: electrode
- 61c: electrode
- 61d: electrode
- 61e: electrode
- 63a: terminal
- 63b: terminal
- 63c: terminal
- 63d: terminal
- 63e: terminal
- 64: connection line

## Claims

1. A thermoelectric conversion element comprising:
a magnetic film provided on a substrate and formed of a magnetic substance that is magnetizable in a predetermined direction having a component parallel to a film surface; and
a plurality of electrodes provided to the magnetic film and made of a material having a spin orbit interaction, the plurality of electrodes being arranged along the predetermined direction,
wherein the thermoelectric conversion element is configured to be capable of outputting a temperature gradient perpendicular to a surface of the magnetic film as a potential difference in any of surfaces of the plurality of electrodes and outputting a temperature gradient parallel to the surface of the magnetic film as a potential difference in any of the surfaces of the plurality of electrodes.

2. A thermoelectric conversion element according to claim 1, wherein the thermoelectric conversion element is configured so that, when the temperature gradient is applied to the magnetic film, a spin current flowing from the magnetic film to the plurality of electrodes is generated and a current is generated in a direction perpendicular to the predetermined direction by an inverse spin-hall effect in the plurality of electrodes.

3. A thermoelectric conversion element according to claim 2, further comprising thermoelectromotive-force outputting means provided at two points of each of the plurality of electrodes to output a thermoelectromotive force generated by the current as a potential difference between the two points on the each of the plurality of electrodes.

4. A thermoelectric conversion element according to any one of claims 1 to 3, further comprising temperature-gradient application means for applying the temperature gradient to the magnetic film.

5. A thermoelectric conversion element according to any one of claims 1 to 4, wherein:
the plurality of electrodes include:
an end electrode provided on an end of the magnetic film, the end electrode being capable of outputting the temperature gradient parallel to the surface of the magnetic film as the potential difference; and
a central electrode capable of outputting the temperature gradient perpendicular to the surface of the magnetic film as the potential difference; and
the central electrode has a larger area on a plane than an area of the end electrode.

6. A thermoelectric conversion element according to claim 5, wherein the end electrode is provided in one or more pair.

7. A thermoelectric conversion element according to any one of claims 1 to 6, wherein at least one of the electrode and the substrate has a larger thermal conductivity in a direction perpendicular to a surface thereof than a thermal conductivity in a direction parallel to the surface.

8. A thermoelectric conversion element according to claim 7, wherein the substrate contains fillers having thermal conduction anisotropy.

9. A thermoelectric conversion element according to claim 7, wherein the substrate includes a slit provided so as to cross the predetermined direction of the magnetic substance, the slit being provided for blocking thermal conduction in a direction parallel to the predetermined direction.

10. A thermoelectric conversion element according to any one of claims 1 to 9, wherein the plurality of electrodes are provided on both surfaces of the magnetic film so as to be opposed to each other.

11. A thermoelectric conversion element according to any one of claims 1 to 10, wherein:
the plurality of electrodes include strip-like electrodes having a longitudinal direction in a direction perpendicular to the predetermined direction; and
the strip-like electrodes are provided so as to be parallel to each other.

12. A thermoelectric conversion element according to claim 11, wherein the plurality of electrodes are connected in series to each other.

13. A thermoelectric conversion element according to claim 12, wherein the plurality of electrodes are configured to be connectable in accordance with the direction of the temperature gradient so that a sum total of added thermoelectromotive forces becomes maximum.

14. A thermoelectric conversion element according to any one of claims 1 to 13, wherein a plurality of the magnetic films and the electrode are laminated.

15. A thermoelectric conversion element according to any one of claims 1 to 14, wherein the magnetic film has a coercive force.

16. A thermoelectric conversion method, comprising:
applying a temperature gradient to the magnetic film of the thermoelectric conversion element according to any one of claims 1 to 15 to generate a spin current flowing from the magnetic film to the plurality of electrodes; and
generating a current in a direction perpendicular to the predetermined direction by an inverse spin-hall effect generated in the plurality of electrodes.
